(19) Europäisches Patentamt / European Patent Office / Office européen des brevets

(11) **EP 4 193 318 B1**

(12) **FASCICULE DE BREVET EUROPEEN**

(45) Date de publication et mention de la délivrance du brevet:
**18.02.2026 Bulletin 2026/08**

(21) Numéro de dépôt: **21745773.8**

(22) Date de dépôt: **15.07.2021**

(51) Classification Internationale des Brevets (IPC):
**G06Q 10/0631** (2023.01)   **F03D 13/30** (2016.01)
**G06Q 50/06** (2024.01)

(52) Classification Coopérative des Brevets (CPC):
**G06Q 10/06312; F03D 13/30; G06Q 50/06;**
F05B 2260/84; Y02E 10/72; Y02E 40/70;
Y04S 10/50

(86) Numéro de dépôt international:
**PCT/EP2021/069748**

(87) Numéro de publication internationale:
**WO 2022/028847 (10.02.2022 Gazette 2022/06)**

(54) **MÉTHODE DE CONSTRUCTION D'UNE FERME ÉOLIENNE DANS UN ESPACE PREDETERMINÉ**

VERFAHREN ZUM BAU EINES WINDPARKS IN EINEM VORGEGEBENEN RAUM

METHOD FOR CONSTRUCTING A WIND FARM IN A PREDETERMINED SPACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.08.2020 FR 2008341**

(43) Date de publication de la demande:
**14.06.2023 Bulletin 2023/24**

(73) Titulaire: **IFP Energies nouvelles**
**92500 Rueil-Malmaison (FR)**

(72) Inventeur: **MALISANI, Paul**
**92852 Rueil-Malmaison Cedex (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**CN-A- 105 119 320     US-A1- 2016 171 401**

- **SONG M X ET AL: "Optimization of wind farm micro-siting for complex terrain using greedy algorithm", ENERGY, ELSEVIER, AMSTERDAM, NL, vol. 67, 14 February 2014 (2014-02-14), pages 454 - 459, XP028633137, ISSN: 0360-5442, DOI: 10.1016/J.ENERGY.2014.01.082**
- **WANG YONG ET AL: "Differential Evolution With a New Encoding Mechanism for Optimizing Wind Farm Layout", IEEE TRANSACTIONS ON INDUSTRIAL INFORMATICS, IEEE SERVICE CENTER, NEW YORK, NY, US, vol. 14, no. 3, 1 March 2018 (2018-03-01), pages 1040 - 1054, XP011678528, ISSN: 1551-3203, [retrieved on 20180301], DOI: 10.1109/TII.2017.2743761**
- **CHUNQIU WAN ET AL: "Wind farm micro-siting by Gaussian particle swarm optimization with local search strategy", RENEWABLE ENERGY, PERGAMON PRESS, OXFORD, GB, vol. 48, 28 April 2012 (2012-04-28), pages 276 - 286, XP028428117, ISSN: 0960-1481, [retrieved on 20120505], DOI: 10.1016/J.RENENE.2012.04.052**
- **GONZALEZ J S ET AL: "Optimization of wind farm turbines layout using an evolutive algorithm", RENEWABLE ENERGY, PERGAMON PRESS, OXFORD, GB, vol. 35, no. 8, 1 August 2010 (2010-08-01), pages 1671 - 1681, XP026983597, ISSN: 0960-1481, [retrieved on 20100220]**

• BANSAL JAGDISH CHAND ET AL: "Wind farm layout using biogeography based optimization", RENEWABLE ENERGY, vol. 107, 1 January 2017 (2017-01-01), pages 386 - 402, XP029940979, ISSN: 0960-1481, DOI: 10.1016/ J.RENENE.2017.01.064

## Description

### Domaine technique

La présente invention concerne une méthode de construction d'une ferme éolienne dans un espace prédéterminé.

Pour répondre aux enjeux environnementaux, les fermes éoliennes ont fait leur apparition. Ces fermes éoliennes sont constituées de plusieurs turbines éoliennes espacées les unes des autres dans un espace délimité. Cet espace délimité peut être sur terre ou en mer. On distingue ainsi des fermes éoliennes terrestres et des fermes éoliennes « offshore », c'est-à-dire en mer.

Les éoliennes de ces fermes sont généralement des éoliennes à axe de rotation horizontal qui disposent d'un système pour orienter l'axe de rotation horizontal dans le sens de la direction du vent, afin de maximiser l'énergie récupérée par l'éolienne. Parfois, l'éolienne est prévue pour s'orienter automatiquement dans la direction du vent.

On connaît également les éoliennes à axe de rotation vertical, qui ont l'avantage de ne pas nécessiter d'orientation dans la direction du vent.

Dans les fermes éoliennes, les sillages générés par les éoliennes peuvent avoir pour effet de diminuer la vitesse de vent en aval de l'éolienne et donc l'énergie récupérée par d'autres éoliennes, notamment celles situées en aval de celles générant ces sillages. Le positionnement des éoliennes dans la ferme est donc important afin de maximiser l'énergie récupérée par la ferme.

Par ailleurs, dans un emplacement choisi pour implanter une ferme éolienne, les caractéristiques locales du vent peuvent varier. En effet, la direction et la vitesse du vent sont notamment des paramètres qui peuvent varier dans le temps à l'emplacement considéré. Ces caractéristiques peuvent notamment être obtenues par des capteurs positionnés à l'emplacement défini et maintenus à cette position pendant plusieurs mois ou plusieurs années de manière à obtenir des données statistiques suffisantes pour caractériser la ressource en vent à l'emplacement choisi. Ces capteurs peuvent notamment être des anémomètres positionnés à une altitude suffisante (de l'ordre de 100m au-dessus du sol) pour caractériser le vent qui sera vu par les éoliennes (c'est-à-dire le vent qui est sensiblement au niveau de l'axe du rotor par exemple). Les données de vent peuvent également être obtenues par télédétection par laser, aussi appelé LiDAR (de l'anglais « Light Detection And Ranging »).

La connaissance statistique du vent à l'emplacement considéré de la ferme permet notamment d'obtenir la distribution de la vitesse du vent (aussi appelée par la suite « répartition de la vitesse du vent »), la distribution de la direction du vent (aussi appelée par la suite « répartition de la direction du vent ») et la probabilité jointe d'occurrence d'une vitesse de vent dans une direction donnée.

Afin de maximiser l'énergie annuelle produite par la ferme, il est donc nécessaire de positionner les éoliennes de manière optimale dans l'emplacement prévu pour la ferme.

On entend par « énergie annuelle produite » ou « production d'énergie annuelle », l'énergie moyenne totale produite par la ferme, donc par l'ensemble des éoliennes de la ferme. Cette énergie moyenne, estimée en tenant compte des données statistiques du vent (répartitions de vitesses de vent, de direction de vent et des probabilités d'occurrence), est basée sur une durée d'un an, d'où le terme « annuelle », de manière à éviter une influence saisonnière qui pourrait fausser les résultats. En effet, le vent, que ce soit sa vitesse ou sa direction, peut varier fortement en fonction des saisons.

L'énergie moyenne est obtenue grâce à la connaissance de la répartition de la direction du vent, de la répartition des vitesses de vent et de la probabilité d'occurrence d'une vitesse de vent dans une direction donnée.

Bien évidemment, l'énergie annuelle produite dépend également des turbines éoliennes choisies.

### Technique antérieure

Pour déterminer un bon positionnement des éoliennes dans l'emplacement prévu pour la ferme, plusieurs méthodes ont été mises au point.

La demande de brevet CN105119320 concerne une méthode basée sur un algorithme d'évolution. Ce type d'algorithme est stochastique, utilisant des processus aléatoires. Ce type d'algorithmes nécessite un nombre de tests importants afin d'obtenir un résultat, ce qui génère un important temps de calcul, et nécessite une mémoire informatique importante.

Les demandes de brevet CN102142103A, CN105139269 et US2016171401 concernent des méthodes de positionnement d'éoliennes basées sur des algorithmes génétiques. Les algorithmes génétiques sont une catégorie d'algorithmes d'évolution. Ils nécessitent une multitude d'évaluations et de croisements de ces évaluations à partir des données réelles (continues) possibles. De ce fait, les algorithmes génétiques sont complexes et nécessitent donc un temps de calcul important et une mémoire informatique importante.

On connaît également les méthodes décrites dans les documents suivants :

- « Wind farm layout optimization with a three-dimensional Gaussian Wake model », Tao and al., Renewable Energy, June 9, 2020: Cette méthode nécessite que l'emplacement prévu pour la ferme soit délimité par un rectangle. En d'autres termes, cette méthode n'est pas adaptée pour des fermes comprenant des espaces non convexes ou même non connexes.

- « Continuous adjoint formulation for wind farm layout optimization », Antonini and al., Applied Energy, July 25, 2018: Cette méthode est basée sur une méthode analytique d'évaluation des effets de sillage. Cette méthode est donc une méthode d'optimisation continue, basée sur des calculs de CFD (de l'anglais « Computational Fluid Dynamics » signifiant « Calculs de dynamique des fluides »), qui nécessite des temps de calcul important et une mémoire informatique importante.

- « A fast and effective local search algorithm for optimizing the placement of wind turbines », Wagner and al, Renewable Energy, October 10, 2012: L'application de cette méthode nécessite des emplacements délimités par un rectangle. De ce fait, elle n'est pas adaptée à des emplacements de formes non connexes ou non connexes.

- « Solving the wind farm layout optimization problem using random search », Feng & Shen, Renewable Energy, January 20, 2015: Cette méthode nécessite des emplacements délimités par des polyèdres. De ce fait, elle n'est pas adaptée à des emplacements de formes non connexes.

- « Greedy robust wind farm layout optimization with feasability guarantee », Quan and Kim, Engineering Optimization, September 6, 2018. Cette méthode est basée sur un algorithme glouton qui prend en compte toutes les positions situées à une distance minimale des éoliennes déjà positionnées dans l'emplacement pour déterminer l'emplacement de l'éolienne suivante. Il nécessite donc un temps de calcul important et une mémoire informatique importante, notamment si la discrétisation de l'emplacement prévu pour la ferme est fine, si l'espace dans lequel on souhaite placer les éoliennes est grand et/ou si le nombre d'éoliennes à positionner est important.

Ainsi, le problème technique que l'invention se propose de résoudre consiste à développer une méthode de construction d'une ferme éolienne qui permette le positionnement optimal d'éoliennes dans des emplacements de forme complexe, tels que les zones non convexes et/ou non connexes, de manière à maximiser l'énergie totale produite par la ferme éolienne, et en minimisant le temps de calcul nécessaire et la mémoire informatique.

**Résumé de l'invention**

Pour se faire, l'invention concerne une méthode de construction d'une ferme éolienne (« wind turbine farm » ou « wind farm » en anglais) à partir d'un nombre prédéfini d'éoliennes dans un espace prédéterminé, la méthode de construction comprenant une première répartition discrète de vitesse de vent, une deuxième répartition discrète de direction de vent et une probabilité d'occurrence de chaque valeur de vitesse de vent et de chaque valeur de direction du vent desdites première et deuxième répartitions discrètes. De plus, l'espace prédéterminé est découpé en un premier maillage discret. La méthode comprend au moins les étapes successives suivantes :

a) on détermine une première disposition des éoliennes dans le premier maillage discret de l'espace prédéterminé par un premier algorithme de positionnement ;
b) On définit un ordre séquentiel de modification des positions des éoliennes déterminées par le premier algorithme de positionnement, puis on réalise au moins les étapes suivantes itérativement, pour au moins une éolienne à repositionner, une par une, dans l'ordre séquentiel défini :

b1) on détermine, pour chaque éolienne à repositionner, de nouvelles positions discrètes possibles de l'éolienne à repositionner.
b2) On calcule la production d'énergie annuelle moyenne du nombre prédéfini d'éoliennes pour chaque position discrète possible de l'éolienne à repositionner, à partir de la première répartition discrète de vitesse de vent, de la deuxième répartition discrète de direction de vent et de la probabilité d'occurrence.
b3) On choisit la position de l'éolienne à repositionner correspondant à la valeur maximale calculée de production d'énergie annuelle et on y place l'éolienne à repositionner ;
b4) On définit une nouvelle disposition des éoliennes dans l'espace prédéterminé correspondant à la disposition où seule l'éolienne à repositionner a été déplacée selon l'état b3 ;

c) on détermine une disposition finale correspondant à la dernière disposition obtenue.

Puis, on construit ladite ferme éolienne (« wind turbine farm » ou « wind farm » en anglais) en érigeant (implantant/construisant) lesdites éoliennes (le nombre prédéfini d'éoliennes) aux positions déterminées de ladite disposition finsale sur le site physique de l'espace prédéterminé de manière à produire de l'énergie, par exemple de l'électricité, à partir du vent. L'invention concerne aussi un produit programme d'ordinateur mettant en œuvre la méthode définie précédemment ainsi qu'une ferme éolienne obtenue en utilisant la méthode définie précédemment.

L'invention concerne une méthode de construction d'une ferme éolienne, la méthode de construction d'une ferme éolienne comprenant une première répartition discrète de vitesse de vent, une deuxième répartition discrète de direction de vent et une probabilité d'occurrence de chaque valeur discrète de vitesse de vent dans chaque valeur discrète de direction du vent desdites première et deuxième répartitions discrètes, ledit espace prédéterminé étant découpé en un premier maillage discret. Dans cette méthode, on effectue au moins les étapes successives suivantes :

a) on détermine une première disposition desdites éoliennes dans le premier maillage discret dudit espace prédéterminé par un premier algorithme de positionnement ;

b) On définit un ordre séquentiel de modification des positions des éoliennes déterminées par le premier algorithme de positionnement, puis on réalise au moins les étapes suivantes, itérativement, pour au moins une éolienne à repositionner, une par une, dans l'ordre séquentiel défini :

b1) on détermine, pour chaque éolienne à repositionner, de nouvelles positions discrètes possibles de l'éolienne à repositionner, en établissant une grille d'au moins une première longueur prédéfinie, la grille étant centrée sur la position de l'éolienne à repositionner, la grille étant découpée en un nombre préétabli de mailles, lesdites nouvelles positions discrètes possibles comprenant les points d'intersections des mailles, les points d'intersection des mailles étant positionnés dans ledit espace prédéterminé et à une distance minimale des positions des autres éoliennes.

b2) On calcule la production d'énergie annuelle moyenne du nombre prédéfini d'éoliennes pour chaque position discrète possible de l'éolienne à repositionner, à partir de ladite première répartition discrète de vitesse de vent, de ladite deuxième répartition discrète de direction de vent et de ladite probabilité d'occurrence.

b3) On choisit la position de l'éolienne à repositionner correspondant à la valeur maximale calculée de production d'énergie annuelle calculée à l'étape b2).

b4) On définit une nouvelle disposition des éoliennes dans ledit espace prédéterminé,

c) on détermine une disposition finale correspondant à la dernière disposition obtenue et on construit ladite ferme éolienne en érigeant le nombre prédéfini d'éoliennes aux positions déterminées de la disposition finale dans le site physique de l'espace prédéterminé de manière à produire de l'électricité à partir du vent

Selon une mise en œuvre de l'invention, avant l'étape a), on collecte des données statistiques du vent, par des moyens de collecte, de préférence un capteur LIDAR, dans l'espace prédéterminé pour déterminer les première et deuxième répartitions discrètes et les probabilités d'occurrence de chaque vitesse de vent dans chaque direction du vent des première et deuxième répartitions discrètes.

Selon une configuration, ledit espace prédéterminé est en deux dimensions.

De préférence, ledit ordre séquentiel est obtenu de manière aléatoire.

De manière préférée, on réitère plusieurs fois l'étape b) de préférence en modifiant l'ordre séquentiel à chaque itération.

De manière encore préférée, pour chaque itération de l'étape b), on choisit une première longueur prédéfinie inférieure à la première longueur prédéfinie de l'itération précédente, ledit nombre préétabli étant le même d'une itération à l'autre et on arrête l'itération de l'étape b) lorsque la première longueur prédéfinie devient inférieure à un premier seuil.

Selon une mise en œuvre de l'invention, ledit espace prédéterminé comprend des zones non connexes.

Selon une variante de l'invention, ledit espace prédéterminé comprend des zones non convexes.

Avantageusement, ledit premier algorithme de positionnement réalise au moins les étapes suivantes :

- on définit arbitrairement la position de la première éolienne ;
- puis pour chaque éolienne à positionner, de manière successive :

on définit des positions potentielles dans ledit premier maillage discret pour l'éolienne à positionner, lesdites positions potentielles comprenant les positions discrètes dudit premier maillage discret situées entre une distance minimale et une distance maximale de toutes les éoliennes positionnées et/ou les positions discrètes de la frontière de l'espace prédéterminé situées à ladite distance minimale de toutes les éoliennes positionnées.

on calcule la production d'énergie annuelle des éoliennes positionnées et de l'éolienne à positionner pour les positions potentielles définies, à partir de ladite première répartition discrète de vitesse de vent, de ladite deuxième répartition discrète de direction de vent et de ladite probabilité d'occurrence.

On choisit la position de l'éolienne à positionner correspondant à la valeur maximale calculée de production d'énergie annuelle

- on détermine ladite première disposition correspondant à la position du nombre prédéfini d'éoliennes dans ledit espace prédéterminé.

Selon un mode de réalisation de l'invention, la position arbitraire correspond à la plus grande somme des coordonnées des positions dudit premier maillage discret.

L'invention concerne aussi un produit programme d'ordinateur mettant en œuvre la méthode décrite précédemment à partir de moyens informatiques.

En outre, l'invention concerne également une ferme éolienne obtenue à partir de la méthode de construction d'une ferme éolienne telle que décrite précédemment.

## Liste des figures

D'autres caractéristiques et avantages de la méthode et des systèmes selon l'invention, apparaîtront à la lecture de la description ci-après d'exemples non limitatifs de réalisations, en se référant aux figures annexées et décrites ci-après.

La figure 1 représente une vue globale des différentes étapes de méthodes de positionnement selon l'invention.

La figure 2 représente une vue détaillée des différentes étapes d'une première méthode de construction d'une ferme éolienne selon l'invention.

La figure 3 représente une vue détaillée des différentes étapes d'une deuxième méthode de construction d'une ferme éolienne selon l'invention.

La figure 4 illustre un exemple d'emplacement complexe pour le positionnement d'éoliennes selon l'invention.

La figure 5 illustre une variante d'un premier algorithme de positionnement selon l'invention.

La figure 6 illustre un premier exemple d'application d'un premier algorithme de positionnement selon l'invention.

La figure 7 illustre un deuxième exemple d'application d'un premier algorithme de positionnement selon l'invention.

La figure 8 illustre une illustration du procédé de recherche local de repositionnement d'une éolienne de la ferme selon l'invention.

La figure 9 illustre différentes étapes du procédé de recherche local de repositionnement d'une éolienne de la ferme selon l'invention.

La figure 10 illustre différentes étapes de la méthode de construction d'une ferme éolienne dans un emplacement complexe comprenant des zones non connexes et une zone non convexe.

La figure 11 illustre une variante de la méthode de construction d'une ferme éolienne pour le même emplacement complexe pour celui de la figure 10.

## Description des modes de réalisation

Afin de faciliter la lecture de la présente description, quelques définitions sont explicitées ci-après.

On entend par « Algorithme glouton » (ou « greedy algorithm » en anglais) un algorithme qui consiste à établir étape par étape un optimum local. Dans le cas d'une ferme éolienne, il consiste à positionner chaque éolienne l'une après l'autre jusqu'à obtenir le positionnement de l'ensemble des éoliennes dans l'espace prédéterminé.

On entend par « Algorithme d'évolution », un algorithme bioinspiré dont l'idée consiste à faire évoluer un ensemble de solutions pour obtenir de meilleurs résultats. Ils sont donc stochastiques et utilisent itérativement des processus aléatoires.

On entend par « Algorithme génétique », un algorithme d'évolution utilisant la notion de sélection naturelle. Ce type d'algorithme peut notamment croiser ou modifier certains paramètres des solutions précédentes en vue d'améliorer des résultats.

On appelle « zones non connexes » des zones pour lesquelles il existe au moins 2 points qui ne peuvent pas être reliés par un chemin continu entièrement contenu dans la zone en question. A l'inverse, une zone connexe est une zone pour laquelle chaque paire de point est reliée par un chemin continu entièrement contenu dans la zone.

On appelle « zone convexe », une zone dans laquelle les segments reliant deux points quelconques de cette zone sont tous entièrement contenus dans la zone. Un cercle, un carré ou un rectangle délimitent tous par exemple des zones convexes.

A l'inverse, une « zone non convexe » est une zone dans laquelle il existe au moins deux points reliés par un segment qui n'est pas entièrement contenu dans la zone. Par exemple, une zone délimitée par un cercle externe et un cercle interne concentriques n'est pas convexe.

L'invention concerne une méthode de positionnement d'un nombre prédéfini d'éoliennes dans un espace prédéterminé ou encore une méthode de construction d'une ferme éolienne (« wind turbine farm » ou « wind farm » en anglais) la méthode de positionnement ou de construction d'une ferme éolienne comprenant une première répartition discrète de vitesse de vent, une deuxième répartition discrète de direction de vent et une probabilité d'occurrence de chaque valeur discrète de vitesse de vent dans chaque valeur discrète de direction du vent desdites première et deuxième répartitions discrètes, l'espace prédéterminé étant découpé en un premier maillage discret. Par maillage discret, on entend que l'espace prédéterminé est découpé en morceaux, par exemple de forme rectangulaire ou carrée, et le maillage discret est constitué par les points déterminés par ce maillage. Par exemple, le premier maillage discret peut être constitué par les points délimitant les morceaux (les quatre points de chaque morceau rectangulaire ou carré par exemple), et/ou par les points d'intersection des morceaux, et/ou par les centres des mailles (par exemple le centre des morceaux carrés ou rectangulaires).

L'utilisation de valeurs discrètes pour la vitesse du vent, la direction du vent et les points discrets du premier maillage discret de l'espace prédéterminé permet de simplifier la méthode et d'accélérer les temps de calculs et de limiter la mémoire informatique nécessaire, comparativement à des méthodes utilisant des données réelles continues. En effet, des valeurs discrètes permettent de limiter le nombre de combinaisons possibles (on parle de méthode combinatoire) alors que des données réelles continues (on parle de méthode continue) fournissent une infinité de solutions. La combinaison des première et deuxième répartitions discrètes et du premier maillage discret permet ainsi d'obtenir une bonne précision du positionnement des différentes éoliennes dans l'espace prédéterminé tout en limitant le temps de calcul nécessaire à cette détermination des positions.

La probabilité d'occurrence de chaque vitesse de vent, dans chaque direction de vent est notamment utilisée pour le calcul de la production d'énergie annuelle moyenne. Cette probabilité peut notamment provenir d'une rose des vents correspondant à l'espace prédéterminé, cette rose des vents étant bien connu de l'homme du métier. Pour établir cette rose des vents, on peut notamment utiliser des moyens de collecte de la vitesse du vent et de la direction du vent, comme un anémomètre positionné sur un mât à une altitude suffisante (entre 80m et 120 m par exemple pour être sensiblement au niveau du moyeu de l'éolienne par exemple), ou par l'intermédiaire d'un capteur LiDAR (acronyme de langue anglaise issu de « Light Detection And Ranging » signifiant « détection et estimation de la distance par la lumière »), positionné à proximité du sol et orienté vers la verticale. Ce moyen de collecte est maintenu en place pendant une longue période, plusieurs mois et idéalement plus d'un an, de manière à pouvoir prendre en compte les variations des caractéristiques du vent en fonction des saisons. En d'autres termes, la méthode peut comprendre une étape pendant laquelle on implante un moyen de collecte, tel qu'un anéomètre, un mât de mesure ou plus avantageusement un capteur LIDAR (de l'anglais « light detection and ranging » pouvant être traduit par télédection par laser) ou tout moyen analogue, pendant une durée prédéterminé sur le site physique de l'espace prédéterminé afin de collecter les données de vent sur ce site. La durée prédéterminée de collecte des mesures peut être d'au moins un an, afin d'avoir les données relatives aux quatre saisons. Ainsi, on peut prévoir une étape de collecte des données statistiques du vent dans l'espace prédéterminé à partir d'au moins un moyen de collecte.

Dans cette méthode, on effectue au moins les étapes successives suivantes :

a) on détermine une première disposition des éoliennes dans le premier maillage discret de l'espace prédéterminé par un premier algorithme de positionnement. De préférence, ce premier algorithme de positionnement peut être un algorithme d'optimisation qui permet d'obtenir une première répartition permettant d'obtenir une grande énergie annuelle produite. Avantageusement, ce premier algorithme de positionnement peut être un algorithme glouton qui positionne chaque éolienne l'une après l'autre de manière à maximiser l'énergie annuelle produite. La première éolienne peut être positionnée arbitrairement dans l'espace prédéterminé (à une valeur discrète du premier maillage discret). La deuxième éolienne sera positionnée à la position discrète du premier maillage discret permettant de maximiser l'énergie annuelle produite des deux éoliennes. La position choisie la n-ième éolienne correspond à la position discrète du premier maillage discret permettant de maximiser l'énergie annuelle produite des n éoliennes. L'utilisation d'un algorithme glouton permet d'obtenir, de manière simple, une première disposition des éoliennes dans l'espace prédéterminé, ce qui permet d'initialiser le procédé de recherche locale d'optimisation de l'étape b) ci-dessous.

b) On définit un ordre séquentiel de modification des positions des éoliennes déterminées par le premier algorithme de positionnement, puis on réalise au moins les étapes suivantes, itérativement, pour au moins une éolienne à repositionner (de préférence, pour toutes les éoliennes du nombre prédéfini d'éoliennes), une par une, dans l'ordre séquentiel défini :

b1) on détermine, pour chaque éolienne à repositionner, de nouvelles positions discrètes possibles de l'éolienne à repositionner, en établissant une grille d'au moins une première longueur prédéfinie (par exemple la grille peut être un premier carré dont la première longueur prédéfinie correspond au côté du premier carré), la grille étant centrée sur la position de l'éolienne à repositionner (la position de l'éolienne à repositionner correspond alors au centre du premier carré par exemple), la grille étant découpée en un nombre préétabli de mailles (les mailles pouvant être par exemple des deuxièmes carrés), les nouvelles positions discrètes possibles comprenant les points d'intersection des mailles (des deuxièmes carrés par exemple) positionnés dans l'espace prédéterminé et à une distance minimale des positions des autres éoliennes. En d'autres termes ici, on cherche à trouver des positions au voisinage de l'éolienne à repositionner où l'éolienne pourrait être implantée. On élimine donc de ces positions celles qui sont trop proches des autres éoliennes et celles qui sont en dehors de l'espace prédéterminé (en dehors de la zone prévue pour l'implantation des éoliennes). L'utilisation de la grille (premier carré par exemple) permet de délimiter de manière globale le voisinage de l'éolienne à repositionner puis le découpage de la grille (premier carré par exemple) en mailles permet d'obtenir des positions discrètes de ce voisinage, plutôt que d'utiliser des positions réelles continues qui alourdirait inutilement le temps de calcul et la mémoire informatique utilisée. De plus, on peut ainsi obtenir une précision locale plus précise pour le repositionnement des éoliennes que le positionnement obtenu dans la première disposition basée sur le premier maillage discret, puisque la discrétisation des mailles peut avantageusement être plus fine que celle du premier maillage discret. De préférence, la distance minimale est de préférence supérieure à deux fois le diamètre du rotor des éoliennes, et de manière préférée, supérieure à quatre fois le diamètre du rotor des éoliennes ;

b2) On calcule la production d'énergie annuelle moyenne du nombre prédéfini d'éoliennes pour chaque position discrète possible de l'éolienne à repositionner, à partir de la première répartition discrète de vitesse de vent, de la deuxième répartition discrète de direction de vent et de la probabilité d'occurrence. Bien entendu, pour calculer la production d'énergie annuelle, les caractéristiques de l'éolienne sont nécessaires, notamment la surface balayée par le rotor et le coefficient de puissance. Cette production d'énergie annuelle tient également compte des effets de sillages qui sont produits par les éoliennes et qui peuvent induire des pertes de puissance pour les éoliennes en aval ou à côté.

b3) On choisit la position (discrète) de l'éolienne à repositionner correspondant à la valeur maximale calculée de production d'énergie annuelle calculée à l'étape b2).

b4) On définit une nouvelle disposition des éoliennes dans l'espace prédéterminé. Cette nouvelle disposition comprend la position modifiée des éoliennes qui ont été repositionnées et celles des éoliennes qui sont à repositionner.

c) On détermine une position finale correspondant à la dernière disposition obtenue et une fois la disposition finale déterminée, on construit les éoliennes suivant la disposition finale dans l'espace prédéterminée (le site physique de l'espace prédéterminéeà de manière à obtenir une ferme éolienne pour générer de l'énergie à partir du vent (en d'autres termes, on construit une ferme éolienne en implantant les éoliennes aux positions de la disposition finale dans l'espace prédéterminé , c'est-à-dire le site physique de l'espace prédéterminé, ladite ferme éolienne étant déterminée pour générer de l'énergie, par exemple de l'électricité, à partir du vent).

En d'autres termes, l'étape b) constitue une méthode de recherche locale d'optimisation basée sur des valeurs discrètes autour de la position d'origine de l'éolienne à repositionner. En effet, à partir de la première disposition obtenue à l'étape b), on modifie une par une la position des éoliennes en recherchant localement autour de la position d'origine, des positions discrètes où l'éolienne pourrait être positionnée (c'est-à-dire en excluant les positions discrètes situées à une distance inférieure à une autre éolienne et celles situées en dehors de la frontière ou de l'espace prédéterminé). L'optimisation de recherche locale consiste alors à évaluer l'énergie annuelle produite pour chaque nouvelle disposition possible, c'est-à-dire en conservant les positions de toutes les éoliennes autres que celle qui est à repositionner et en prenant en compte chaque position discrète possible de l'éolienne à repositionner. La position retenue est celle qui maximise l'énergie annuelle produite. Une fois la position retenue, cette position est maintenue pour les autres éoliennes suivantes à repositionner. En d'autres termes, pour la suite des modifications des positions des éoliennes, on utilise une nouvelle disposition, basée sur les positions des éoliennes qui ont déjà été modifiées.

L'étape c) permet la construction d'une ferme éolienne avec une optimisation du positionnement des éoliennes pour maximiser l'énergie totale récupérée par les éoliennes.

Ainsi, la méthode de positionnement d'éoliennes ou de construction de ferme éolienne dans un espace prédéterminé de l'invention utilise une optimisation basée sur une approche purement combinatoire.

Les étapes a) et b) sont mises en œuvre par des moyens informatiques, notamment un ordinateur, un téléphone portable ou une tablette.

Selon un mode de réalisation, la production d'énergie annuelle peut être estimée par la formule suivante :

[Math1]

$$aep = 8760 \cdot E_{w_s, w_p}\{P(f, w_s, w_p)\}$$

Où aep est la production d'énergie annuelle de la ferme d'éoliennes et

$E_{w_s, w_p}\{P(f, w_s, w_p)\}$ est l'espérance de la puissance totale produite par la ferme éolienne (par le nombre prédéfini d'éoliennes dans l'espace prédéterminé) pour chaque vitesse de vent $w_s$ et chaque direction de vent $w_p$. De ce fait, la puissance totale produite par la ferme prend en compte une répartition statistique de chaque vitesse de vent $w_s$ dans chaque direction du vent $w_p$, par exemple par une distribution de Weibull.

Dans le cas où les rotors des éoliennes sont systématiquement orientés dans un plan orthogonal à la direction du vent $w_p$, la puissance totale produite par la ferme peut s'écrire :

[Math2]

$$P(f, w_s, w_p) = \sum_{f=1}^{N} P_f(w_s, w_p)$$

Où N est le nombre prédéfini d'éoliennes de la ferme dans l'espace prédéterminé, Pf est la puissance instantanée fournie par chaque éolienne f, dans la ferme, pour chaque vitesse de vent $w_s$ dans chaque direction du vent $w_p$.

Dans le cas où certains rotors des éoliennes seraient dans un plan désaxé du plan orthogonal à la direction du vent $w_p$ (autrement dit, l'éolienne n'est pas orientée face au vent mais est désaxé de celui-ci), un facteur correctif peut être pris en compte pour tenir compte de l'effet du désaxage. Ce facteur correctif peut notamment être issu de simulations CFD (de l'anglais « Computational Fluid Dynamics » signifiant « Calculs de dynamique des fluides »).

La puissance instantanée Pf de chaque éolienne f dans la ferme peut s'écrire :

[Math3]

$$P_f(w_s, w_p) = \frac{1}{2} \cdot \rho \cdot S \cdot v_f^3(w_s) \cdot C_{pf}[v_f(w_s)]$$

Avec $\rho$ est la masse volumique de l'air, S est la surface balayée par le rotor de l'éolienne f, $v_f(w_s)$ la vitesse du vent au niveau du rotor de l'éolienne f et le coefficient de puissance $C_{pf}$ de l'éolienne f dépendant de la vitesse $v_f(w_s)$ du vent au niveau du rotor de l'éolienne f, le coefficient de puissance $C_{pf}$ étant une caractéristique de l'éolienne f.

En effet, les effets de sillage des éoliennes situées en amont et/ou sur le côté de l'éolienne f peuvent impacter la production d'énergie de l'éolienne f. Ce sillage peut générer une diminution de la vitesse du vent au niveau de l'éolienne f et/ou des turbulences du vent. Ces effets de sillage ont pour impact que la vitesse $v_f$ au niveau du rotor de l'éolienne ne correspond plus à la vitesse $w_s$ et que le coefficient de puissance $C_{pf}$ est alors également impacté.

Les impacts des effets de sillage pris en compte dans l'équation [Math3] peuvent notamment être basés sur des modèles de sillage. Ces modèles de sillage peuvent notamment traduire :

- une réduction de la vitesse du vent en amont de l'éolienne f du fait du sillage issu d'une éolienne en amont. Un tel modèle, bien connu de l'homme du métier est le modèle de sillage de Jensen (décrit dans la publication « A simple model for Cluster Efficiency », Katic, Hojstrup and Jensen, EWEC 1986, notamment au paragraphe 2.1 de cette publication),
- une augmentation de l'intensité turbulente du vent,
- et/ou une superposition de sillages de plusieurs éoliennes en amont sur une même éolienne f, comme décrit dans la publication « A note on wind generator interaction » Jensen, DTU, 1983. Cette superposition de sillage peut combiner les effets de réduction de vitesse comme dans la publication citée précédemment et/ou d'intensité turbulente du vent de plusieurs sillages.

Les modèles de sillage peuvent également être déterminés à partir de calculs CFD (de l'anglais « Computational Fluid Dynamics » signifiant « Calculs de dynamique des fluides »).

De préférence, l'ordre séquentiel défini est différent de l'ordre dans lequel les éoliennes ont été positionnées pour obtenir la première disposition, via l'algorithme glouton par exemple. Ainsi, la précision de l'optimisation est améliorée. L'étape b) correspond à un deuxième algorithme d'optimisation de la position de chaque éolienne dans l'espace prédéterminé.

c) on détermine une disposition finale correspondant à la dernière disposition obtenue. La disposition finale correspond donc aux positions des éoliennes une fois qu'elles ont toutes été repositionnées à l'étape b). Elle représente donc une optimisation de la première disposition de manière à améliorer l'énergie annuelle produite par le nombre prédéfini d'éoliennes dans l'espace prédéterminé.

Une fois la disposition finale trouvée, on peut alors construire les éoliennes suivant la disposition finale dans l'espace prédéterminé de manière à obtenir une ferme éolienne. La ferme éolienne ainsi construite permet de maximiser l'énergie totale produite et récupérée du vent sur le site physique de l'espace prédéterminé.

De manière avantageuse, l'espace prédéterminé peut être en deux dimensions. Ainsi, on ne tient pas compte de l'altitude du sol par rapport au niveau de la mer. En d'autres termes, on s'affranchit des variations de dénivelé du sol pour l'implantation des éoliennes. Cela permet de simplifier les calculs, tout en permettant une précision suffisante.

Préférentiellement, l'ordre séquentiel peut être obtenu de manière aléatoire. En effet, en utilisant une fonction aléatoire pour l'ordre séquentiel, on améliore la qualité de l'optimisation en évitant des chemins d'optimisation basés sur des ordres préétablis, ces chemins pouvant biaiser les résultats d'optimisation.

Selon un mode de réalisation de l'invention, le nombre préétabli peut être le multiple d'un carré d'un nombre entier (de préférence, quatre fois le multiple du carré d'un nombre entier). De ce fait, la position discrète de l'éolienne à repositionner se trouve sur une des positions discrètes possibles à réévaluer. En effet, en utilisant quatre fois le multiple d'un carré d'un nombre entier, on peut discrétiser la grille en deux dimensions en ayant une première ligne (par exemple verticale) d'intersection des mailles correspondant à un premier axe de symétrie de la grille (du premier carré par exemple) et une deuxième ligne (horizontale par exemple) d'intersection des mailles correspondant à un deuxième axe de symétrie de la grille.

De ce fait, le nombre préétabli peut notamment prendre les valeurs suivantes : 4, 16, 25, 64, 100 etc.

Selon une configuration préférée de l'invention, on peut réitérer plusieurs fois l'étape b). Ainsi, on effectue plusieurs boucles d'optimisation de recherche locale de repositionnement des éoliennes, ce qui permet encore d'améliorer l'énergie annuelle produite.

De préférence, pour chaque itération de l'étape b), on peut modifier l'ordre séquentiel de modifications des positions des éoliennes. Ainsi, la recherche locale de repositionnement est améliorée. Lorsque l'ordre séquentiel est obtenu à chaque fois de manière aléatoire, on évite l'influence de plusieurs chemins d'optimisation (par chemin d'optimisation, on entend l'optimisation peu à peu du repositionnement qui est influencé par l'ordre séquentiel défini) entre eux. De ce fait, l'énergie annuelle produite peut être augmentée.

Selon une mise en œuvre avantageuse de l'invention, pour chaque itération de l'étape b), on peut choisir une première longueur prédéfinie inférieure à la première longueur prédéfinie de l'itération précédente, le nombre préétabli étant le même d'une itération à l'autre et on peut arrêter l'itération de l'étape b) lorsque la première longueur prédéfinie devient inférieure à un premier seuil. De ce fait, à chaque itération de l'étape b), le voisinage local dans lequel on cherche à améliorer la position de l'éolienne à repositionner est réduit par rapport à l'itération qui lui précède. De plus, comme le nombre préétabli est invariant d'une itération à l'autre, la discrétisation du voisinage est de plus en plus fine d'une itération à l'autre. De ce fait, on améliore peu à peu la précision de la position de l'éolienne. La définition du premier seuil permet d'arrêter les itérations à un niveau de précision des positions suffisantes pour l'implantation et qui n'apporterait plus de gain significatif pour l'énergie annuelle produite (ou un gain qui serait dans l'intervalle d'incertitudes des calculs). Par exemple, le premier seuil peut être entre de 1m à 10m, de préférence entre 4 et 6m de manière à obtenir un bon compromis entre temps de calcul, mémoire informatique utilisée, précision des positions et gain sur l'énergie annuelle produite.

Avantageusement, l'espace prédéterminé peut comprendre des zones non connexes. De ce fait, l'espace prédéterminé peut correspondre à des emplacements réels prévus pour l'implantation des éoliennes, par exemple une ferme prévu dans un emplacement comprenant deux zones séparées par une route de largeur significative (plusieurs mètres, voire plusieurs dizaines de mètres), telle qu'une autoroute .

Préférentiellement, l'espace prédéterminé peut comprendre des zones non convexes. Ainsi, l'espace prédéterminé peut correspondre à des emplacements réels de forme complexe tels qu'un espace délimité par une colline ou une falaise escarpée, le littoral, le passage d'une rivière, un fleuve ou toute autre étendue d'eau. En offshore, l'espace prédéterminé peut comprendre des zones non convexes qui peuvent notamment être déterminées en tenant compte de la bathymétrie, de la nature du sol, des frontières avec d'autres pays, de canaux de navigation, de passage de câbles ou de pipeline par exemples.

Selon un mode de réalisation de l'invention, le premier algorithme de positionnement peut réaliser au moins les étapes suivantes :

- on définit arbitrairement la position de la première éolienne. Ainsi, la position de la première éolienne est choisie dans une valeur discrète du premier maillage discret.

- puis pour chaque éolienne à positionner, de manière successive (une par une) :

on définit des positions potentielles du premier maillage discret pour l'éolienne à positionner, les positions potentielles comprenant les positions discrètes du premier maillage discret situées entre une distance minimale et une distance maximale (par exemple, la distance maximale est d'au moins quatre fois le diamètre des éoliennes et de préférence au moins huit fois le diamètre des éoliennes) de toutes les éoliennes positionnées et/ou les positions discrètes de la frontière de l'espace prédéterminé situées à une distance minimale de toutes les éoliennes positionnées. En d'autres termes, on sélectionne des positions du premier maillage discret où serait avantageusement positionnée la prochaine éolienne. De ce fait, on limite le nombre de calcul et la mémoire informatique nécessaire pour définir la position choisie, ce qui permet d'accélérer les calculs. De plus, lorsque les valeurs discrètes sont choisies dans les positions situées entre une distance minimale et une distance maximale des éoliennes déjà positionnées, on améliore les chances de positionner un maximum d'éoliennes dans l'espace prédéterminé. En positionnant le plus d'éoliennes dans l'espace prédéterminé, on peut améliorer l'énergie annuelle produite. Le choix de positionner les éoliennes également sur toute la frontière située à une distance minimale des éoliennes positionnées permet virtuellement d'utiliser un plus grand espace que si on dispose les éoliennes à l'intérieur strict de l'espace, frontière non comprise. En utilisant un plus grand espace, on peut produire plus d'énergie.

On calcule la production d'énergie annuelle de la ferme à partir des éoliennes positionnées et des différentes positions potentielles définies de l'éolienne à positionner. De ce fait, pour chaque position potentielle définie, est associée une valeur de production d'énergie annuelle. De plus, le calcul de la production d'énergie annuelle prend en compte la première répartition discrète de vitesse de vent, la deuxième répartition discrète de direction de vent et la probabilité d'occurrence. Ce calcul fait également intervenir de manière connue les caractéristiques des éoliennes, à savoir notamment la surface balayée par le rotor de l'éolienne, le coefficient de traînée et/ou le coefficient de puissance.

On choisit la position de l'éolienne à positionner correspondant à la valeur maximale calculée de production d'énergie annuelle à l'étape précédente. Ainsi, on maximise l'énergie annuelle produite par les éoliennes dont la position est définie dans l'espace prédéterminé. Ces positions définies serviront de base pour la détermination de la position de la prochaine éolienne, notamment pour définir les positions potentielles du premier maillage discret.

- on détermine la première disposition correspondant à la position du nombre prédéfini d'éoliennes dans l'espace prédéterminé, une fois que toutes les éoliennes ont été positionnées.

De ce fait, le premier algorithme de positionnement est un algorithme glouton qui comprend une étape de position arbitraire de la première éolienne, puis qui itérativement positionne une éolienne supplémentaire dans une zone choisie de l'espace prédéterminé jusqu'à ce que toutes les éoliennes du nombre prédéfini soient positionnées dans l'espace prédéterminé. Cet algorithme glouton permet, grâce à l'étape de sélection des positions potentielles, d'accélérer le temps de calcul, tout en positionnant les éoliennes de manière judicieuse. Un tel algorithme permet d'obtenir une première disposition adaptée pour l'étape b) d'optimisation locale de positionnement de chaque éolienne.

Selon une variante de l'invention, la position arbitraire peut correspondre à la plus grande somme des coordonnées des positions du premier maillage discret. Ainsi, la position de l'éolienne est positionnée à une extrémité de l'espace prédéterminé. Ce choix permet de pouvoir positionner plus d'éoliennes dans l'espace prédéterminé et donc de permettre plus de choix potentiels aux positions du nombre prédéfini d'éoliennes dans l'espace prédéterminé. Ainsi, il existe plus de marge de manœuvre pour l'optimisation de l'énergie annuelle produite par la ferme d'éoliennes.

L'invention concerne également un produit programme d'ordinateur mettant en œuvre la méthode telle que décrite précédemment à partir de moyens informatiques, comme un ordinateur, un téléphone portable ou une tablette. Le produit programme d'ordinateur peut être téléchargeable depuis un réseau de communication et/ou enregistré sur un support lisible par ordinateur et/ou exécutable par un processeur ou un serveur, comprenant des instructions de code de programme pour la mise en œuvre du procédé selon l'une des caractéristiques précédentes, lorsque le programme est exécuté sur un ordinateur ou sur un téléphone portable. En effet, la méthode décrite précédemment est particulièrement adaptée pour être implémentée sur des moyens informatiques. Elle peut ainsi être mise en œuvre de manière simple et des résultats peuvent être obtenus rapidement.

En outre, l'invention concerne une ferme éolienne obtenue à partir de la méthode de positionnement d'un nombre prédéfini d'éoliennes dans un espace prédéterminé (ou de construction d'une ferme éolienne) telle que décrite précédemment. En effet, une fois le positionnement des éoliennes obtenu, on peut construire physiquement (ou implanter) les différentes éoliennes aux positions déterminées par la méthode dans le site physique de l'espace prédéterminé. On obtient ainsi une ferme dont l'énergie totale annuelle est optimisée.

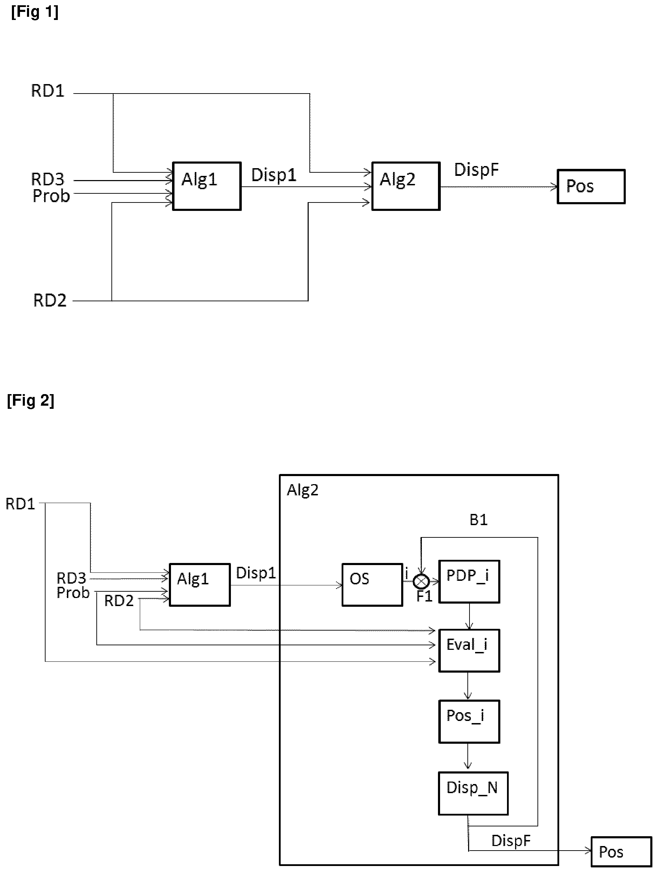

La figure 1 illustre, de manière schématique et non limitative, une vue globale de la méthode de positionnement d'un nombre prédéfini d'éoliennes (ou de construction d'une ferme éolienne) dans un espace prédéterminé selon l'invention.

Cette méthode comprend notamment un premier algorithme de positionnement Alg1. Ce premier algorithme de positionnement Alg1 a pour données d'entrée au moins une première répartition discrète RD1 de vitesses de vent, une deuxième répartition discrète RD2 de directions du vent, un premier maillage discret RD3 de l'espace prédéterminé dans lequel on peut implanter le nombre prédéfini d'éoliennes et la probabilité d'occurrences Prob de chaque vitesse de vent dans chaque direction de vent. Il peut notamment également utiliser les caractéristiques des éoliennes nécessaires à la détermination de l'énergie annuelle produite. Les données de vent, vitesse, direction et probabilité d'occurrence de chaque valeur de vitesse dans chaque direction peuvent notamment être obtenues à partir de moyens de collecte lors d'une étape préliminaire. Ces données peuvent notamment servir à établir une rose des vents connue de l'homme du métier.

Le premier algorithme de positionnement Alg1 détermine une première disposition Disp1 du nombre prédéfini d'éoliennes dans l'espace prédéterminé. Cette première disposition Disp1 est perfectible mais de suffisamment bonne qualité pour permettre les optimisations locales des étapes ultérieures. Ce premier algorithme de positionnement Alg1 peut être un algorithme glouton.

Cette première disposition Disp1 obtenue rapidement grâce à l'algorithme glouton est utilisée comme donnée d'entrée dans un deuxième algorithme Alg2. Ce deuxième algorithme Alg2 est un algorithme d'optimisation qui modifie, une à une, la position d'au moins une éolienne de la première disposition Disp1, de préférence qui modifie la position de toutes les éoliennes de la première disposition Disp1, de manière à augmenter l'énergie annuelle produite par la ferme en testant différentes positions discrètes possibles de chaque éolienne autour de sa position initiale (ou de sa dernière position définie).

Pour déterminer l'énergie annuelle produite, le deuxième algorithme utilise notamment la première répartition discrète RD1 des vitesses de vent, la deuxième répartition discrète RD2 des directions du vent.

Une fois toutes les éoliennes repositionnées, on obtient une disposition finale DispF du nombre prédéfini d'éoliennes dans l'espace prédéterminé. On peut alors positionner (construire/implanter/ériger) Pos les éoliennes dans le site physique correspondant à l'espace prédéterminé.

La figure 2 illustre, de manière schématique et non limitative, une vue détaillée d'un premier mode de réalisation de la méthode de positionnement d'un nombre prédéfini d'éoliennes (ou de construction d'une ferme éolienne) dans un espace prédéterminé selon l'invention.

Cette méthode comprend notamment un premier algorithme de positionnement Alg1. Ce premier algorithme de positionnement Alg1 a pour données d'entrée au moins une première répartition discrète RD1 de vitesses de vent, une deuxième répartition discrète RD2 de directions du vent, un premier maillage discret RD3 de l'espace prédéterminé dans lequel on peut implanter le nombre prédéfini d'éoliennes et la probabilité d'occurrences Prob de chaque vitesse de vent dans chaque direction de vent. Il peut notamment également utiliser les caractéristiques des éoliennes nécessaires à la détermination de l'énergie annuelle produite. Des modèles de sillage sont utilisés pour la déterminer de l'énergie annuelle produite.

Les données de vent, vitesse, direction et probabilité d'occurrence de chaque valeur de vitesse dans chaque direction peuvent notamment être obtenues à partir de moyens de collecte lors d'une étape préliminaire. Ces données peuvent notamment servir à établir une rose des vents connue de l'homme du métier.

Le premier algorithme de positionnement Alg1 détermine une première disposition Disp1 du nombre prédéfini d'éoliennes dans l'espace prédéterminé. Cette première disposition Disp1 est perfectible mais de suffisamment bonne qualité pour permettre les optimisations locales des étapes ultérieures. Ce premier algorithme de positionnement Alg1 peut être un algorithme glouton.

Cette première disposition Disp1 obtenue rapidement grâce à l'algorithme glouton est utilisée comme donnée d'entrée dans un deuxième algorithme Alg2. Ce deuxième algorithme Alg2 est un algorithme d'optimisation qui modifie, une à une la position des différentes éoliennes de la première disposition Disp1, de manière à augmenter l'énergie annuelle produite par la ferme en testant différentes positions discrètes possibles de chaque éolienne autour de sa position initiale.

De manière plus détaillée, le deuxième algorithme Alg2 comprend les étapes suivantes :

- on définit un ordre séquentiel OS de modification des positions des éoliennes, une par une. Cet ordre séquentiel OS peut notamment être obtenu par une fonction aléatoire.
- Puis de manière itérative, on modifie la position d'au moins une éolienne i, de préférence de chaque éolienne i, en réalisant les sous-étapes suivantes :

  * on détermine des positions discrètes possibles PDP_i pour l'éolienne i, ces positions discrètes possibles PDP_i se trouvant au voisinage de la position de l'éolienne i à repositionner (les autres éoliennes restant à leur position, soit la position initiale issue de la première disposition, soit la position déjà repositionnée). On peut par exemple définir un certain périmètre autour de la position de l'éolienne à repositionner (une grille avec une ou deux longueurs prédéterminées, un carré dont le côté est d'une certaine longueur, un cercle d'un certain diamètre etc...). On détermine des positions discrètes dans ce périmètre par exemple en découpant ce périmètre en mailles, les positions discrètes pouvant alors être les centres des mailles et/ou les intersections des mailles et/ou les points définissant les mailles, et on supprime de ce périmètre les positions discrètes qui sont trop proches des autres éoliennes : en d'autres termes, on supprime de ce périmètre les positions discrètes qui se trouvent à une distance inférieure à une distance minimale requise, par exemple, la distance minimale requise peut être d'au moins deux fois le diamètre du rotor des éoliennes. On supprime également de ce périmètre les positions qui se trouvent en dehors de l'espace prédéterminé.

* on évalue Eval_i ensuite l'énergie annuelle produite pour chaque disposition possible (pour chaque position discrète possible PDP_i de l'éolienne i à repositionner, les autres éoliennes restant à la dernière position qui leur a été fixée). L'énergie annuelle produite prend en compte les premières et deuxièmes répartitions discrètes RD1 et RD2 des vitesses et directions du vent, ainsi que la probabilité d'occurrence Prob de chaque vitesse de vent dans chaque direction du vent. Ainsi, à la fin de cette étape d'évaluation, une énergie annuelle produite correspond à chaque position discrète possible PDP_i de l'éolienne i à repositionner.

* on retient comme position Pos_i de l'éolienne i la position discrète possible PDP_i qui correspond à la valeur maximale de l'énergie annuelle produite à l'étape Eval_i.

* On obtient ainsi une nouvelle disposition Disp_N des éoliennes dans l'espace déterminé. Cette nouvelle disposition comprend les dernières positions des éoliennes déjà positionnées ainsi que la nouvelle position Pos_i de l'éolienne i.

La boucle B1 permet ensuite de sélectionner F1 l'éolienne suivante de l'ordre séquentiel (i devient i+1) défini afin d'effectuer la même procédure pour les éoliennes suivantes.

Une fois toutes les éoliennes repositionnées, on obtient une disposition finale DispF du nombre prédéfini d'éoliennes dans l'espace prédéterminé. On peut alors positionner (c'est-à-dire construire physiquement, implanter ou ériger) Pos les éoliennes dans le site physique correspondant à l'espace prédéterminé.

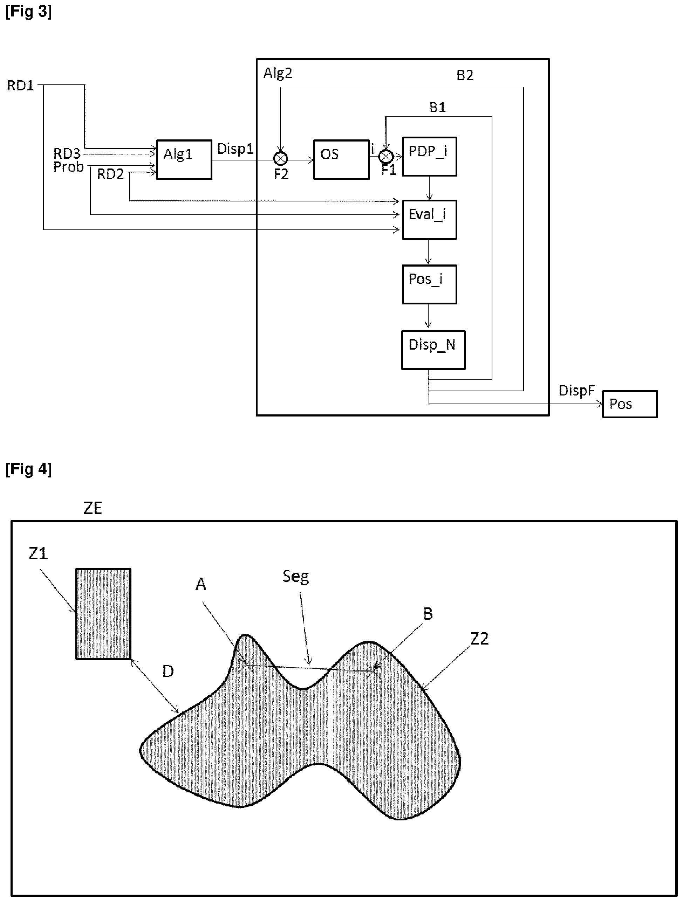

La figure 3 illustre, de manière schématique et non limitative, une variante de la figure 2. Les références identiques à celles de la figure 2 correspondent aux mêmes éléments et ne seront pas redétaillés.

La figure 3 se distingue de la figure 2 par l'ajout d'une deuxième boucle B2 dans le deuxième algorithme Alg2.

En effet, une fois que toutes les éoliennes ont été repositionnées par la boucle B1, il est ici prévu de modifier plusieurs fois la position de ces éoliennes. Pour ce faire, on réitère plusieurs fois les étapes de détermination de l'ordre séquentiel OS, et de la boucle B1 pour chacune des éoliennes, une par une, la boucle B1 comprenant pour chaque éolienne i à repositionner la détermination des positions discrètes possibles PDP_i, l'évaluation de l'énergie annuelle produite Eval_i pour chaque position discrète possible, le choix de la position Pos_i de l'éolienne i à repositionner et la définition de la nouvelle disposition Disp_N.

En réitérant plusieurs fois ces étapes, on peut affiner les positions des éoliennes dans l'espace prédéterminé et améliorer l'énergie annuelle produite par la ferme. Modifier à chaque fois l'ordre séquentiel (par un tirage aléatoire à chaque fois par exemple) permet encore d'améliorer l'énergie annuelle produite.

La boucle B2 peut se terminer par exemple lorsque le gain d'énergie annuelle par rapport à l'itération précédente est inférieur à une certaine valeur, par exemple inférieure à 0,5%.

Une fois la boucle B2 terminée, la dernière disposition Disp_N obtenue devient la disposition finale DispF et on peut alors positionner (construire/ériger/implanter) Pos les éoliennes aux positions prévues selon la disposition finale DispF pour obtenir une ferme éolienne.

La figure 4 illustre, de manière schématique et non limitative, un exemple d'espace prédéterminé adapté à la mise en œuvre de la méthode de positionnement de l'invention (ou de construction d'une ferme éolienne de l'invention).

L'espace prédéterminé peut notamment comprendre une première zone Z1 et une deuxième zone Z2, zones représentées par les hachures verticales. Ces zones Z1 et Z2 sont non connexes. En effet, une distance minimale D non nulle apparaît entre les deux zones Z1 et Z2. De plus, la zone Z1 est rectangulaire. De ce fait, elle est convexe. La zone Z2 est de forme complexe, non convexe. En effet, si on considère les deux points A et B, on observe qu'une partie du segment Seg qui relie les points A et B est située en dehors de la zone Z2.

Pour identifier les zones Z1 et Z2 de l'espace prédéterminé dans une troisième zone plus grande ZE, englobant ces deux zones Z1 et Z2, on peut utiliser une matrice booléenne. La troisième zone ZE est de forme rectangulaire, ce qui est plus facile à traiter informatiquement, que des zones non connexes et/ou non convexes comme Z1 et Z2. La matrice booléenne associe à chaque valeur discrète (position discrète) de la zone ZE une valeur égale à 1 si la position discrète est située dans la zone Z1 ou Z2 et une valeur 0 si elle est située en dehors de Z1 et Z2. Cette matrice booléenne permet de définir l'espace déterminé utilisé pour la méthode. On peut, à partir de cette matrice booléenne, déterminer la ou les frontières de l'espace prédéterminé. En effet, un point sera considéré comme faisant partie de la frontière si sa valeur dans la matrice booléenne est à 1 et s'il a parmi ses voisins directs, au moins un point qui a une valeur dans la matrice booléenne à 0.

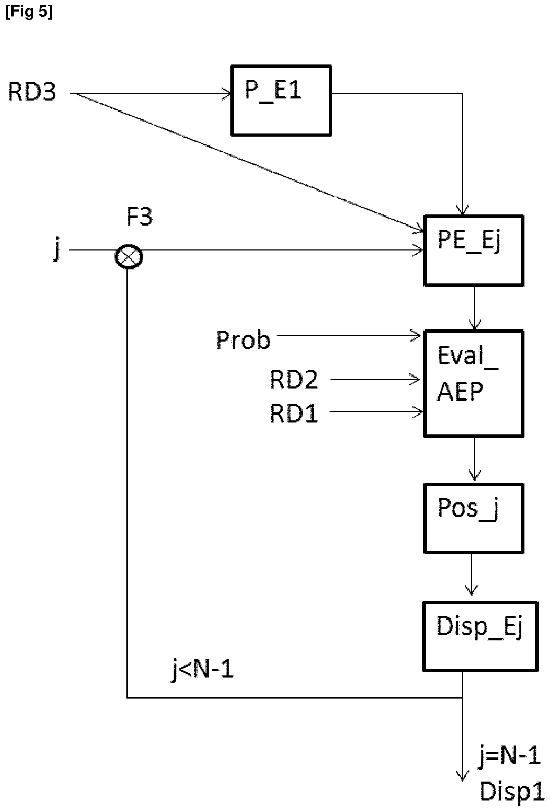

La figure 5 illustre, de manière schématique et non limitative, un exemple de premier algorithme de positionnement selon l'invention.

Ce premier algorithme de positionnement est un algorithme glouton.

A partir du premier maillage discret RD3 de l'espace prédéterminé, on définit la position de la première éolienne P_E1, par exemple de manière arbitraire.

Puis pour chaque éolienne j, on cherche une position de manière à maximiser l'énergie annuelle produite.

Ainsi, de manière itérative selon F3, on définit, pour chaque éolienne, une par une, des positions potentielles PE_Ej pour l'éolienne j à positionner, les positions potentielles PE_Ej étant délimitées par le premier maillage discret RD3 de l'espace prédéterminé. Par exemple, les positions potentielles peuvent correspondre aux positions du premier maillage discret RD3 situées entre une distance minimale et une distance maximale des éoliennes déjà positionnées dans l'espace prédéterminé et/ou aux positions correspondantes à la frontière de l'espace prédéterminé.

Une fois ces positions potentielles PE_Ej définies pour l'éolienne j à positionner, on évalue Eval_AEP, pour chacune de ces positions potentielles PE_Ej l'énergie annuelle produite des éoliennes déjà positionnées et de l'éolienne j à positionner dans l'espace prédéterminé. Pour cette évaluation Eval_AEP, on utilise notamment les première et deuxièmes répartitions discrètes RD1 et RD2 des vitesses et directions du vent ainsi que la probabilité d'occurrence Prob de chaque vitesse du vent dans chaque direction du vent. On peut, de manière connue utiliser les caractéristiques des éoliennes et les effets de sillage préalablement décrits dans cette description.

On peut alors choisir la position Pos_j de l'éolienne j, position correspondant à la valeur maximale de l'énergie annuelle produite à l'étape précédente.

On peut alors définir une nouvelle disposition Disp_Ej des éoliennes positionnées (y compris l'éolienne j) dans l'espace prédéterminé. Cette nouvelle disposition Disp_Ej servira à l'itération suivante pour déterminer les positions potentielles PE_Ej de la nouvelle éolienne à positionner et pour l'évaluation de l'énergie annuelle produite Eval_AEP.

On effectue la boucle F3 pour, j allant de 1 à N-1, N étant le nombre prédéfini d'éoliennes dans l'espace prédéterminé, compte tenu du fait que la première éolienne est positionnée de manière étape à l'étape P_E1.

Une fois toutes les éoliennes positionnées (c'est-à-dire lorsque j=N-1), la dernière disposition trouvée Disp_Ej correspond alors à la première disposition Disp1. On peut alors construire une ferme éolienne en implantant (érigeant/-construisant) les éoliennes aux positions de la dernière disposition trouvée, correspondant à la disposition finale, de manière à produire de l'énergie à partir du vent, sur le site physique de l'espace prédéterminé.

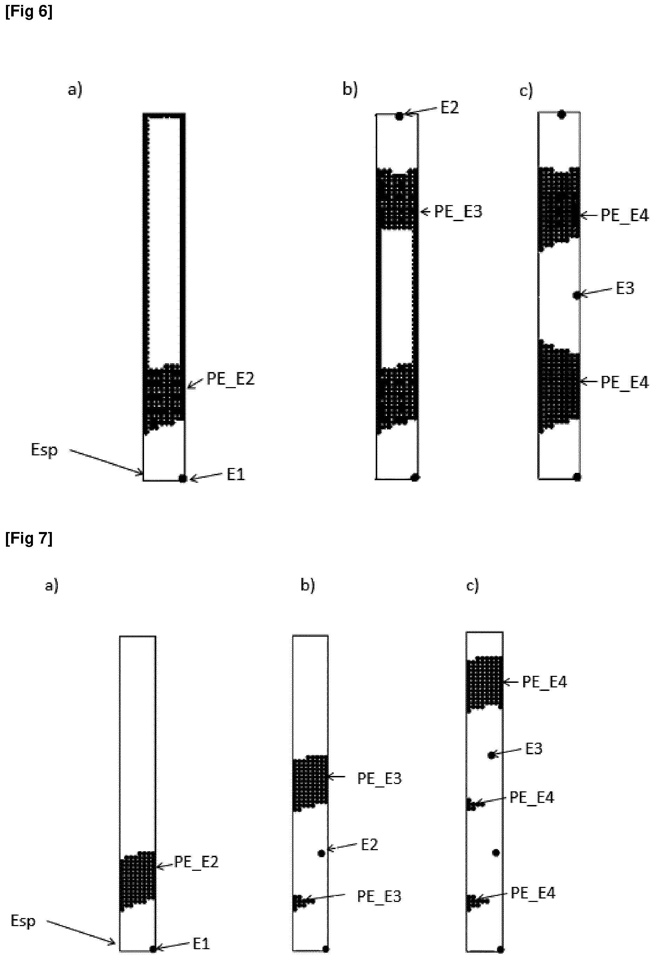

La figure 6 illustre, de manière schématique et non limitative, les étapes de positionnements des trois premières éoliennes par un premier algorithme de positionnement glouton. Les schémas a), b) et c) correspondent respectivement aux étapes de positionnement des première, deuxième et troisième éoliennes.

L'espace prédéterminé Esp défini ici est rectangulaire. La première éolienne E1, positionnée arbitrairement au coin en bas à droite du rectangle de l'espace prédéterminé Esp. Ainsi, la première éolienne E1 est positionnée sur la frontière de l'espace prédéterminé Esp.

Une fois cette éolienne positionnée, les positions potentielles pour déterminer la position de la deuxième éolienne PE_E2 correspondent aux valeurs discrètes situées sur la frontière de l'espace prédéterminé Esp située à une distance supérieure à une distance minimale de la première éolienne E1 et les valeurs discrètes situées dans l'espace prédéterminé Esp situé à une distance comprise entre la distance minimale et une distance maximale. Ici, la distance minimale est de deux fois le diamètre du rotor des éoliennes et la distance maximale est de quatre fois le diamètre du rotor des éoliennes.

Une fois le calcul de l'énergie annuelle produite pour chacune des positions PE_E2, on détermine la position de la deuxième éolienne E2 à la position située sur le schéma b). La deuxième éolienne est donc sur la frontière de l'espace prédéterminé Esp.

Ces positions des deux premières éoliennes permettent de définir les positions potentielles PE_E3 pour la troisième éolienne à positionner. Ces positions potentielles PE_E3 comprennent les positions discrètes situées dans l'espace prédéterminé situées entre la distance minimale et la distance maximale des éoliennes déjà positionnées (les première et deuxième éoliennes E1 et E2), ainsi que les positions discrètes situées sur la frontière de l'espace prédéterminé Esp à une distance supérieure à la distance minimale des éoliennes E1 et E2.

Une fois le calcul de l'énergie annuelle produite pour chacune des positions PE_E3, on détermine la position de la troisième éolienne E3 à la position située sur le schéma c). La troisième éolienne est donc également sur la frontière de l'espace prédéterminé Esp.

Ces positions des trois premières éoliennes permettent de définir les positions potentielles PE_E4 pour la quatrième éolienne à positionner. Ces positions potentielles PE_E4 comprennent les positions discrètes situées dans l'espace prédéterminé situées entre la distance minimale et la distance maximale des éoliennes déjà positionnées (les éoliennes E1, E2 et E3). A noter, il n'y a pas de positions discrètes situées sur la frontière de l'espace prédéterminé Esp à une distance supérieure à la distance minimale des éoliennes E1, E2 et E3, en dehors des zones définies précédemment car toutes les autres valeurs de la frontière ne respectent plus les conditions de distances minimales avec les éoliennes E1 à E3.

La figure 7 illustre, de manière schématique et non limitative, une variante des étapes de positionnements des trois premières éoliennes par un premier algorithme de positionnement glouton. Les schémas a), b) et c) correspondent respectivement aux étapes de positionnement des première, deuxième et troisième éoliennes.

La figure 7 se distingue de la figure 6 par le fait que les positions potentielles sont définies uniquement par les valeurs discrètes de l'espace situées entre la distance minimale et la distance maximale des éoliennes déjà positionnées. En clair, on ne prend plus en compte, en supplément, les valeurs discrètes situées sur la frontière de l'espace prédéterminé situées à une distance supérieure à la distance maximale des éoliennes déjà positionnées.

L'espace prédéterminé Esp défini ici est rectangulaire. La première éolienne E1, positionnée arbitrairement au coin en bas à droite du rectangle de l'espace prédéterminé Esp. Ainsi, la première éolienne E1 est positionnée sur la frontière de l'espace prédéterminé Esp.

Une fois cette éolienne positionnée, les positions potentielles pour déterminer la position de la deuxième éolienne PE_E2 correspondent aux valeurs discrètes situées dans l'espace prédéterminé Esp (y compris la frontière) situées à une distance comprise entre la distance minimale et une distance maximale. Ici, la distance minimale est de deux fois le diamètre du rotor des éoliennes et la distance maximale est de quatre fois le diamètre du rotor des éoliennes.

Une fois le calcul de l'énergie annuelle produite pour chacune des positions PE_E2, on détermine la position de la deuxième éolienne E2 à la position située sur le schéma b). La deuxième éolienne n'est donc pas sur la frontière de l'espace prédéterminé Esp, contrairement à la solution du schéma b) de la figure 6, alors que l'espace prédéterminé est identique et que les première et deuxième répartitions discrètes et le premier maillage discret sont identiques, que les probabilités d'occurrence sont identiques et que la position de la première éolienne E1 est identique.

Ces positions des deux premières éoliennes permettent de définir les positions potentielles PE_E3 pour la troisième éolienne à positionner. Ces positions potentielles PE_E3 comprennent les positions discrètes situées dans l'espace prédéterminé situées entre la distance minimale et la distance maximale des éoliennes déjà positionnées (les première et deuxième éoliennes E1 et E2).

Une fois le calcul de l'énergie annuelle produite pour chacune des positions PE_E3, on détermine la position de la troisième éolienne E3 à la position située sur le schéma c).

Ces positions des trois premières éoliennes E1 à E3 permettent de définir les positions potentielles PE_E4 pour la quatrième éolienne à positionner. Ces positions potentielles PE_E4 comprennent les positions discrètes situées dans l'espace prédéterminé situées entre la distance minimale et la distance maximale des éoliennes déjà positionnées (les éoliennes E1, E2 et E3).

On peut noter que les positions des trois éoliennes E1 à E3 de la figure 7 sont très différentes de celles de la figure 6, alors que tous les paramètres sont identiques. La distinction n'est liée qu'à la définition des positions potentielles qui intègrent (selon la figure 6) ou non (selon la figure 7) les positions discrètes de la frontière de l'espace prédéterminé Esp situées à une distance supérieure à la distance maximale de toutes les éoliennes déjà positionnées.

L'avantage de la solution de la figure 7 par rapport à la figure 6 est que les positionnements des éoliennes, les unes après les autres, permettent des positionnements plus proches des éoliennes entre elles, ce qui permet ainsi de positionner plus d'éoliennes dans l'espace prédéterminé. Cela est particulièrement intéressant lorsqu'on a un nombre prédéfini d'éoliennes important dans un espace prédéterminé restreint (en proportion du nombre prédéfini d'éoliennes à placer).

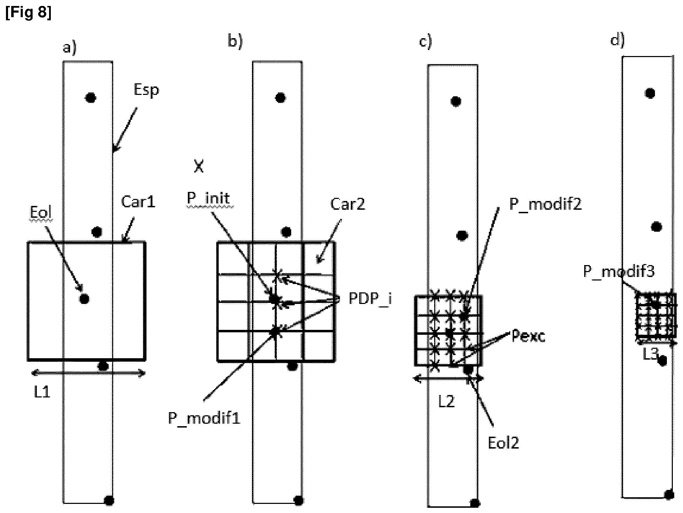

La figure 8 illustre, de manière schématique et non limitative, un exemple d'application d'un procédé d'optimisation locale du positionnement d'une éolienne à partir d'une première disposition.

Cette figure présente quatre schémas a), b), c) et d) montrant différentes étapes de repositionnement d'une éolienne.

La méthode de positionnement des éoliennes appliquées ici (ou de construction d'une ferme éolienne) correspond à la figure 3.

Sur le schéma a), on note une première disposition de cinq éoliennes matérialisées par les petits ronds dans un espace prédéterminé Esp défini par le rectangle gris.

On cherche à améliorer la position de l'éolienne Eol. Pour se faire, on définit une première grille Car 1, la grille étant ici un carré centré sur l'éolienne Eol et de côté L1.

Sur le schéma b), on discrétise la grille Car1 en seize (mais cela pourrait être un nombre différent, notamment, en quatre, vingt-cinq, cent etc.) mailles Car2, ici les mailles Car2 sont des deuxièmes carrés de côté plus petit que la grille Car1 de manière à discrétiser la grille Car1. Et on définit les positions discrètes possibles PDP_i comme les points d'intersection des mailles Car2. Les positions discrètes possibles PDP_i sont matérialisées par les croix positionnées aux points d'intersection des mailles dans l'espace prédéterminé Esp et à une distance suffisante des autres éoliennes. Sur le schéma b), trois positions discrètes PDP_i sont possibles. Ainsi, après optimisation locale de l'énergie annuelle au niveau des trois positions possibles PDP_i, la position de l'éolienne Eol passe de la position P_init à la position P_modif1.

Une fois toutes les éoliennes repositionnées, on peut réitérer l'étape b) de la méthode de positionnement (ou de construction d'une ferme éolienne).

On va alors redéfinir une nouvelle grille (un nouveau premier carré), de côté L2 inférieur au côté L1 utilisée à l'itération précédente. Cette nouvelle grille centrée autour de la position P_modif1 est à nouveau discrétisée dans le nombre préétabli de mailles (ici seize deuxièmes carrés) et on définit de nouvelles positions discrètes possibles correspondant aux croix positionnées aux points d'intersection des mailles situées dans l'espace prédéterminé Esp et à une distance suffisante des autres éoliennes. On peut noter que les points d'intersection Pexc sont situés à une distance trop proche de l'éolienne Eol2 (ils sont à une distance de l'éolienne Eol2 inférieure à la distance minimale). Ils ne sont donc pas pris en compte dans les positions discrètes possibles pour repositionner l'éolienne Eol. Après cette nouvelle itération, la position de l'éolienne Eol se trouve à la position P_modif2.

Une fois toutes les éoliennes repositionnées, on peut itérer une nouvelle fois l'étape b) de la méthode de positionnement (ou de construction d'une ferme éolienne).

Sur le schéma d), on effectue une nouvelle recherche locale de repositionnement de l'éolienne Eol. On redéfinit une nouvelle grille (un nouveau premier carré) centré sur la position P_modif2, de côté L3 inférieur au côté L2. La nouvelle grille est discrétisée en le nombre préétabli (identique aux grilles des itérations précédentes) de mailles (ici seize deuxièmes carrés). Sur ces seize mailles, seize points d'intersection sont situés dans l'espace prédéterminé Esp et à une distance suffisante des autres éoliennes (à une distance supérieure à la distance minimale des autres éoliennes) et servent alors de positions discrètes possibles, matérialisées par les croix, pour le repositionnement de l'éolienne Eol.

Le calcul de l'énergie annuelle basée sur la position de l'éolienne Eol à ces différentes positions discrètes possibles permet de définir la position P_modif3 correspondant à l'énergie annuelle produite maximale.

On note que pour les schémas c) et d), les positions des éoliennes autres que Eol sont inchangées mais elles pourraient l'être compte tenu que les schémas c) et d) correspondent à de nouvelles itérations de l'étape b) pour laquelle une nouvelle disposition des éoliennes est établie en entrée de la nouvelle itération.

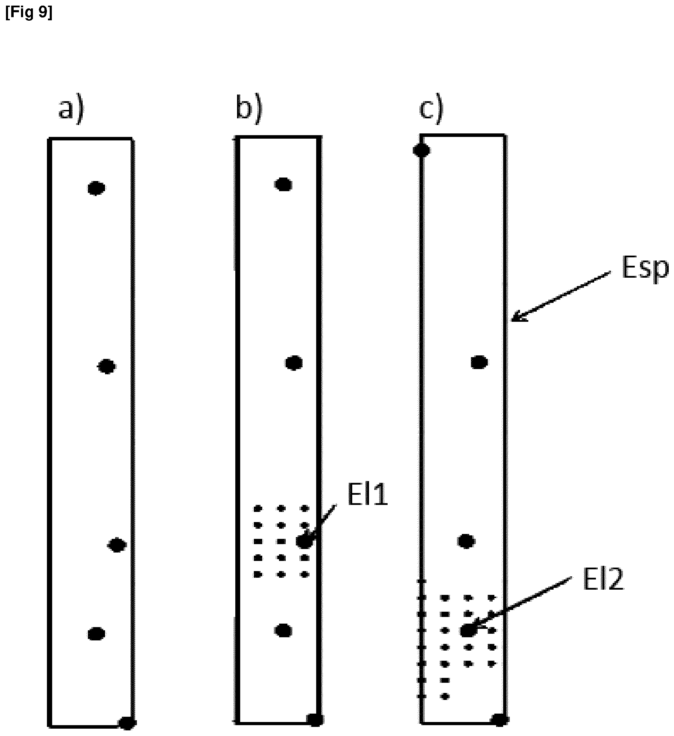

La figure 9, illustre de manière schématique et non limitative, plusieurs étapes de la méthode de positionnement d'un nombre préétabli d'éoliennes (ou de construction d'une ferme éolienne) dans un espace prédéterminé Esp.

L'espace prédéterminé Esp est ici de forme rectangulaire.

Le schéma a) présente une première disposition de cinq éoliennes, matérialisées par les points gris foncés, dans l'espace prédéterminé Esp. Cette première disposition est issue d'un premier algorithme glouton comme celui de la figure 7.

Sur le schéma b), on cherche à améliorer la position de l'éolienne El1 de manière à augmenter l'énergie annuelle produite. Pour se faire, on procède en déterminant une grille (un premier carré) centrée sur la position de l'éolienne El1 et on discrétise cette grille en un nombre préétabli de mailles (des deuxièmes carrés par exemple) dont les points d'intersection situés dans l'espace prédéterminé Esp et à une distance suffisante des autres éoliennes (à une distance supérieure à la distance minimale des autres éoliennes, la distance minimale étant par exemple de deux fois le diamètre du rotor des éoliennes) correspondent aux positions discrètes possibles, matérialisées par les petits points gris autour de l'éolienne El1.

Le schéma c) correspond à une nouvelle itération de l'étape b). Sur cette nouvelle itération, la disposition des éoliennes a été modifiée. En effet, à la fin d'une itération de l'étape b), les éoliennes ont été repositionnées l'une après l'autre.

Sur le schéma c), on cherche à repositionner l'éolienne El2. Pour se faire, on procède en déterminant une grille (premier carré) centrée sur la position de l'éolienne El2 et on discrétise cette grille en un nombre préétabli de mailles (ici des deuxièmes carrés). Les intersections de ces mailles situées dans l'espace prédéterminé Esp, à une distance supérieure à la distance minimale des autres éoliennes (deux fois le diamètre du rotor des éoliennes par exemple) correspondent aux positions discrètes possibles pour l'éolienne El2. Ces positions discrètes possibles correspondent aux petits points gris clairs qui sont autour de l'éolienne El2.

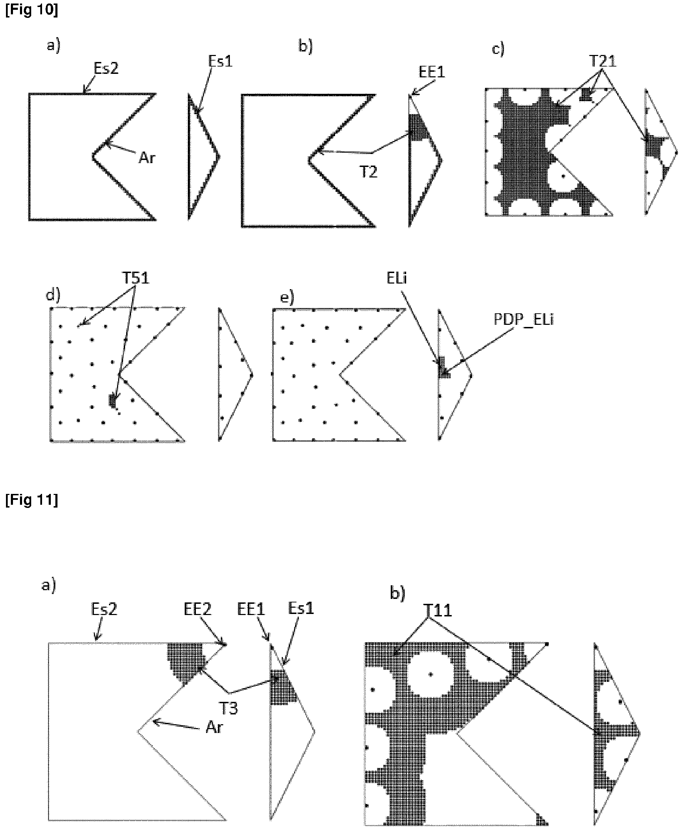

La figure 10 illustre, de manière schématique et non limitative, un exemple d'application de la méthode de positionnement d'éoliennes (ou de construction d'une ferme éolienne) dans un espace prédéterminé complexe.

L'espace prédéterminé est ici constitué de deux zones non connexes Es1 et Es2. De plus, la zone Es2 est non convexe compte tenu de la partie de la frontière Ar en forme de triangle vers l'intérieur de la zone Es2.

Sur le schéma a), les points gris représentent la frontière de l'espace prédéterminé et correspondent aux emplacements discrets où la première éolienne peut être implantée.

Sur le schéma b), une seule éolienne EE1 est positionnée, matérialisée par le point isolé gris, en haut de la zone Es1. Les agglomérats de points en gris foncé T2 représentent les positions potentielles de la prochaine éolienne à positionner dans l'espace prédéterminé. Ils correspondent aux points discrets des frontières des zones Es1 et Es2 situés à une distance suffisante (c'est-à-dire supérieure à une distance minimale qui peut être de deux fois le diamètre de l'éolienne) de l'éolienne EE1, ainsi qu'aux positions discrètes à l'intérieur de la zone Es1 situées à une distance comprise entre une distance minimale et une distance maximale de l'éolienne EE1.

Le schéma c) correspond à une étape où 20 éoliennes, matérialisées par les points isolés gris, ont été positionnées par le premier algorithme de positionnement glouton. Les agglomérats de points en gris foncé T21 correspondent aux positions potentielles pour la 21ème éolienne à positionner par le premier algorithme de positionnement glouton.

Le schéma d) correspond à une étape où 50 éoliennes, matérialisées par les points isolés gris, ont été positionnées par le premier algorithme de positionnement glouton. Les agglomérats de points en gris foncé T51 correspondent aux positions potentielles pour la 51ème éolienne à positionner par le premier algorithme de positionnement glouton.

Le schéma e) correspond à une étape où on cherche à améliorer la position d'une éolienne ELi par une optimisation locale de sa position. La disposition des 52 éoliennes a été établie préalablement par le premier algorithme de positionnement glouton et les positions actuelles de chacune des 52 éoliennes correspondent aux gros points isolés gris du schéma e).

Les petits points gris positionnés autour de l'éolienne ELi sont les positions discrètes possibles PDP_ELi pour le repositionnement de l'éolienne ELi. Les énergies annuelles produites sont estimées sur la base des positions des éoliennes autres que l'éolienne ELi de la disposition du schéma e) et sur les différentes positions discrètes possibles PDP_ELi pour l'éolienne ELi.

La figure 11 illustre, de manière schématique et non limitative, une variante de la méthode de positionnement (ou de construction d'une ferme éolienne) pour l'espace complexe prédéterminé, identique à celui de la figure 10.

L'espace prédéterminé comprend deux zones non connexes Es1 et Es2. De plus, la zone Es2 est une zone non convexe compte tenu de la partie de la frontière Ar en forme de triangle orienté vers l'intérieur de la zone Es2.

Pour le positionnement des éoliennes par le premier algorithme de positionnement glouton, les positions potentielles correspondent aux positions discrètes situées dans l'espace prédéterminé à une distance comprise entre une distance minimale et une distance maximale des éoliennes déjà positionnées. Les points de la frontière situés à une distance supérieure à la distance maximale des éoliennes déjà positionnées ne sont pas pris en compte afin de maximiser le nombre d'éoliennes à implanter dans l'espace prédéterminé, alors qu'ils étaient pris en compte dans le premier algorithme de positionnement de la figure 10, comme on peut le voir sur le schéma b) de la figure 10, par les positions potentielles T2 de la deuxième éolienne.

Sur le schéma a) de la figure 11, deux éoliennes EE1 et EE2 ont été positionnées. Les positions potentielles de la troisième éolienne à positionner T3 correspondent aux agglomérats de points gris.

Sur le schéma b) de la figure 11, dix éoliennes, matérialisées par les points gris isolés, ont été positionnées. Les positions potentielles de la onzième éolienne à positionner T11 correspondent aux agglomérats de points gris.

**Exemples**

Un premier exemple consiste à positionner les éoliennes dans l'espace prédéterminé de la figure 7, selon une méthode continue (utilisant des données réelles continues et non des valeurs discrètes) de l'art antérieur et selon la méthode de la figure 3 de l'invention où on définit les positions discrètes possibles à partir d'une grille (un premier carré) centrée sur la position de l'éolienne à repositionner, la grille étant discrétisée en un nombre préétabli de mailles (qui sont ici des deuxièmes carrés), et les intersections des mailles positionnées dans l'espace prédéterminé et à une distance suffisante (supérieure à une distance minimale) des autres éoliennes forment les positions discrètes possibles.

Les éoliennes à implanter sont des éoliennes de 2,5 MW, la distance minimale entre les éoliennes est de 4 fois le diamètre du rotor des éoliennes.

Pour la méthode selon l'invention, la distance maximale entre les éoliennes utilisée pour le premier algorithme de positionnement glouton est de 8 fois le diamètre du rotor des turbines. La longueur du premier carré de la première itération est de 500m, le seuil permettant d'arrêter les itérations de l'étape b) est de 5m, le nombre préétabli est de 4, et le rapport de longueur d'un premier carré à la longueur du premier carré de l'itération précédente de l'étape b) est de 0,8.

La méthode de l'art antérieur est réalisée sur le logiciel FarmShadow™ (IFP Energies nouvelles, France).

La première répartition de vitesse de vent comprend des valeurs discrètes espacées de 0,5m/s et la deuxième répartition de direction du vent comprend des valeurs discrètes espacées de 1°.

La méthode de l'invention permet d'estimer un gain d'environ 2,2% sur l'énergie annuelle produite par rapport à la méthode de l'art antérieur, ce qui montre l'efficacité de la méthode pour améliorer l'énergie récupérée par la ferme tout en réduisant le temps de calcul et la mémoire informatique utilisée.

Le deuxième exemple d'application est celui de la figure 10. Tout d'abord, cette application qui comprend un espace prédéterminé avec des zones non connexes et non convexe n'est pas applicable avec une méthode continue, qui nécessite une zone convexe et connexe pour être appliquée, généralement de forme rectangulaire. 52 éoliennes de 10 MW ont été positionnées dans cet espace prédéterminé.

Le gain d'énergie annuelle produite par la disposition finale des éoliennes, par comparaison à la première disposition obtenue à partir du premier algorithme de positionnement glouton est d'environ 2,84%. Cela témoigne d'une part de la bonne première disposition obtenue à partir du premier algorithme et d'autre part de l'efficacité du procédé de recherche locale d'optimisation de la position de chaque éolienne.

La méthode de positionnement des éoliennes dans un espace prédéterminé (ou de construction d'une ferme éolienne) permet des calculs rapides, simples tout en assurant une position précise et optimisée des éoliennes dans un espace prédéterminé, espace prédéterminé qui peut être non connexe et/ou non convexe de manière à maximiser l'énergie annuelle totale produite par la ferme éolienne.

**Revendications**

1. Méthode de construction d'une ferme éolienne dans un espace prédéterminé (Esp) à partir d'un nombre prédéfini d'éoliennes, la méthode de construction comprenant une première répartition discrète de vitesse de vent (RD1), une deuxième répartition discrète de direction de vent (RD2) et une probabilité d'occurrence (Prob) de chaque valeur discrète de vitesse de vent dans chaque valeur discrète de direction du vent desdites première et deuxième répartitions discrètes (RD1, RD2), ledit espace prédéterminé (Esp) étant découpé en un premier maillage discret (RD3), pour laquelle on effectue au moins les étapes successives suivantes :

   a) on détermine une première disposition (Disp1) desdites éoliennes dans le premier maillage discret (RD3) dudit espace prédéterminé (Esp) par un premier algorithme de positionnement (Alg1) ;
   b) On définit un ordre séquentiel (OS) de modification des positions des éoliennes déterminées par le premier algorithme de positionnement (Alg 1), puis on réalise au moins les étapes suivantes, itérativement, pour au moins une éolienne à repositionner, une par une, dans l'ordre séquentiel (OS) défini :

   b1) on détermine, pour chaque éolienne à repositionner, de nouvelles positions discrètes possibles (PDP_i) de l'éolienne à repositionner, en établissant une grille d'au moins une première longueur prédéfinie, la grille étant centrée sur la position de l'éolienne à repositionner, la grille étant découpée en un nombre préétabli de mailles, lesdites nouvelles positions discrètes possibles comprenant les points d'intersections des mailles, les points d'intersection des mailles étant positionnés dans ledit espace prédéterminé (Esp) et à une distance minimale des positions des autres éoliennes ;
   b2) On calcule la production d'énergie annuelle moyenne (Eval_i) du nombre prédéfini d'éoliennes pour chaque position discrète possible de l'éolienne à repositionner, à partir de ladite première répartition discrète de vitesse de vent (RD1), de ladite deuxième répartition discrète de direction de vent (RD2) et de ladite probabilité d'occurrence (Prob) ;
   b3) On choisit la position (Pos_i) de l'éolienne à repositionner correspondant à la valeur maximale calculée de production d'énergie annuelle calculée à l'étape b2) ;
   b4) On définit une nouvelle disposition des éoliennes (Disp_N) dans ledit espace prédéterminé (Esp) ; et

   c) on détermine une disposition finale (DispF) correspondant à la dernière disposition obtenue, et on construit ladite ferme éolienne en érigeant lesdites éoliennes aux positions de ladite disposition finale sur le site de l'espace prédéterminé de manière à générer de l'énergie à partir du vent, les étapes a) et b) étant mises en œuvre par des moyens informatiques, de préférence un ordinateur, un téléphone portable ou une tablete.

2. Méthode de construction d'une ferme éolienne selon la revendication 1, pour laquelle, avant l'étape a), on collecte des données statistiques du vent, par des moyens de collecte, de préférence un capteur LIDAR, dans l'espace prédéterminé (Esp) pour déterminer les première et deuxième répartitions discrètes (RD1, RD2) et les probabilités d'occurrence (Prob) de chaque vitesse de vent dans chaque direction du vent des première et deuxième répartitions discrètes (RD1, RD2).

3. Méthode de construction d'une ferme éolienne selon l'une des revendications précédentes, pour laquelle ledit espace prédéterminé (Esp) est en deux dimensions.

4. Méthode de construction d'une ferme éolienne selon l'une des revendications précédentes, pour laquelle ledit ordre séquentiel (OS) est obtenu de manière aléatoire.

5. Méthode de construction d'une ferme éolienne selon l'une des revendications précédentes, pour laquelle on réitère (B2) plusieurs fois l'étape b) de préférence en modifiant l'ordre séquentiel (OS) à chaque itération.

6. Méthode de construction d'une ferme éolienne selon la revendication 5, pour laquelle, pour chaque itération (B2) de l'étape b), on choisit une première longueur prédéfinie inférieure à la première longueur prédéfinie de l'itération précédente, ledit nombre préétabli étant le même d'une itération à l'autre et on arrête l'itération de l'étape b) lorsque la première longueur prédéfinie devient inférieure à un premier seuil.

7. Méthode de construction d'une ferme éolienne selon l'une des revendications précédentes, pour laquelle ledit espace prédéterminé (Esp) comprend des zones non connexes (Es1, Es2).

8. Méthode de construction d'une ferme éolienne selon l'une des revendications précédentes, pour laquelle ledit espace prédéterminé (Esp) comprend des zones non convexes (Z2, Es2).

9. Méthode de construction d'une ferme éolienne selon l'une des revendications précédentes, pour lequel ledit premier algorithme de positionnement (Alg1) réalise au moins les étapes suivantes :

  - on définit arbitrairement la position (P_E1) de la première éolienne (EE1) ;
  - puis pour chaque éolienne à positionner, de manière successive :

    on définit des positions potentielles (PE_Ej) dans ledit premier maillage discret (RD3) pour l'éolienne à positionner, lesdites positions potentielles (PE_Ej) comprenant les positions discrètes du premier maillage discret (RD3) situées entre une distance minimale et une distance maximale de toutes les éoliennes positionnées et/ou les positions discrètes de la frontière de l'espace prédéterminé (Esp) situées à ladite distance minimale de toutes les éoliennes positionnées ;
    on calcule la production d'énergie annuelle (Eval_AEP) des éoliennes positionnées et de l'éolienne à positionner pour les positions potentielles (PE_Ej) définies, à partir de ladite première répartition discrète (RD1) de vitesse de vent, de ladite deuxième répartition (RD2) discrète de direction de vent et de ladite probabilité d'occurrence (Prob) ;
    On choisit la position (Pos_j) de l'éolienne à positionner correspondant à la valeur maximale calculée de production d'énergie annuelle :

      - on détermine ladite première disposition (Disp_Ej) correspondant à la position du nombre prédéfini d'éoliennes dans ledit espace prédéterminé (Esp).

10. Méthode de construction d'une ferme éolienne selon la revendication 9, pour laquelle la position arbitraire correspond à la plus grande somme des coordonnées des positions de dudit premier maillage discret (RD3).

11. Produit programme d'ordinateur téléchargeable depuis un réseau de communication et/ou enregistré sur un support lisible par ordinateur et/ou exécutable par un processeur ou un serveur, comprenant des instructions de code de programme pour la mise en oeuvre de la méthode selon l'une des revendications précédentes lorsque le programme est exécuté sur un ordinateur ou un téléphone portable.

12. Ferme éolienne obtenue à partir de la méthode de construction d'une ferme éolienne selon l'une des revendications 1 à 10 précédentes.

**Patentansprüche**

1. Verfahren zum Aufbauen eines Windparks in einem vorbestimmten Raum (Esp) ausgehend von einer vorgegebenen Anzahl von Windenergieanlagen, wobei das Verfahren zum Aufbauen eine erste diskrete Windgeschwindigkeitsverteilung (RD1), eine zweite diskrete Windrichtungsverteilung (RD2) und eine Eintrittswahrscheinlichkeit (Prob) jedes diskreten Windgeschwindigkeitswerts in jedem diskreten Windrichtungswert der ersten und der zweiten diskreten Verteilung (RD1, RD2) umfasst, wobei der vorbestimmte Raum (Esp) in ein erstes diskretes Netz (RD3) zerlegt wird, wobei bei dem Verfahren mindestens die folgenden aufeinanderfolgenden Schritte durchgeführt werden:

  a) man bestimmt eine erste Anordnung (Disp1) der Windenergieanlagen in dem ersten diskreten Netz (RD3) des vorbestimmten Raums (Esp) durch einen ersten Positionierungsalgorithmus (Alg1);
  b) Man definiert eine sequenzielle Reihenfolge (OS) zur Änderung der durch den ersten Positionierungsalgorithmus (Alg 1) bestimmten Positionen der Windenergieanlagen, dann führt man iterativ mindestens die folgenden Schritte für mindestens eine umzupositionierende Windenergieanlage, eine nach der anderen, in der definierten sequenziellen Reihenfolge (OS) aus:

    b1) man bestimmt, für jede umzupositionierende Windenergieanlage, neue mögliche diskrete Positionen (PDP_i) der umzupositionierenden Windenergieanlage, indem man ein Gitter mit mindestens einer ersten vorgegebenen Länge erstellt, wobei das Gitter auf die Position der umzupositionierenden Windenergieanlage zentriert ist, wobei das Gitter in eine zuvor ermittelte Anzahl von Maschen zerlegt ist, wobei die neuen möglichen diskreten Positionen die Schnittpunkte der Maschen umfassen, wobei die Schnittpunkte der Maschen in dem vorbestimmten Raum (Esp) und in einem minimalen Abstand von den Positionen der anderen Windenergieanlagen positioniert sind;

b2) Man berechnet die mittlere jährliche Energieerzeugung (Eval_i) der vorgegebenen Anzahl von Windenergieanlagen für jede mögliche diskrete Position der umzupositionierenden Windenergieanlage ausgehend von der ersten diskreten Windgeschwindigkeitsverteilung (RD1), der zweiten diskreten Windrichtungsverteilung (RD2) und der Eintrittswahrscheinlichkeit (Prob);

b3) Man wählt die Position (Pos_i) der umzupositionierenden Windenergieanlage, die dem im Schritt b2) berechneten maximalen Wert der jährlichen Energieerzeugung entspricht;

b4) Man definiert eine neue Anordnung der Windenergieanlagen (Disp_N) in dem vorbestimmten Raum (Esp); und

c) man bestimmt eine endgültige Anordnung (DispF), die der letzten erhaltenen Anordnung entspricht, und man baut den Windpark auf, indem man die Windenergieanlagen an den Positionen der endgültigen Anordnung am Standort des vorbestimmten Raums errichtet, so dass Energie aus Wind erzeugt wird, wobei die Schritte a) und b) durch informationstechnische Mittel, bevorzugt einen Computer, ein Smartphone oder ein Tablet, implementiert werden.

2. Verfahren zum Aufbauen eines Windparks nach Anspruch 1, wobei man vor dem Schritt a) statistische Winddaten durch Erfassungsmittel, bevorzugt einen LIDAR-Sensor, in dem vorbestimmten Raum (Esp) erfasst, um die erste und die zweite diskrete Verteilung (RD1, RD2) und die Eintrittswahrscheinlichkeit (Prob) jeder Windgeschwindigkeit in jeder Windrichtung der ersten und der zweiten diskreten Verteilung (RD1, RD2) zu bestimmen.

3. Verfahren zum Aufbauen eines Windparks nach einem der vorhergehenden Ansprüche, wobei der vorbestimmte Raum (Esp) zweidimensional ist.

4. Verfahren zum Aufbauen eines Windparks nach einem der vorhergehenden Ansprüche, wobei die sequenzielle Reihenfolge (OS) zufällig erhalten wird.

5. Verfahren zum Aufbauen eines Windparks nach einem der vorhergehenden Ansprüche, wobei man den Schritt b) mehrmals iteriert (B2), bevorzugt, indem man bei jeder Iteration die sequenzielle Reihenfolge (OS) ändert.

6. Verfahren zum Aufbauen eines Windparks nach Anspruch 5, wobei man bei jeder Iteration (B2) des Schritts b) eine erste vorgegebene Länge wählt, die geringer als die erste vorgegebene Länge der vorhergehenden Iteration ist, wobei die zuvor ermittelte Anzahl von einer Iteration zur anderen gleich ist, und man die Iteration des Schritts b) stoppt, wenn die erste vorgegebene Länge geringer als ein erster Schwellenwert wird.

7. Verfahren zum Aufbauen eines Windparks nach einem der vorhergehenden Ansprüche, wobei der vorbestimmte Raum (Esp) nicht zusammenhängende Bereiche (Es1, Es2) umfasst.

8. Verfahren zum Aufbauen eines Windparks nach einem der vorhergehenden Ansprüche, wobei der vorbestimmte Raum (Esp) nicht konvexe Bereiche (Z2, Es2) umfasst.

9. Verfahren zum Aufbauen eines Windparks nach einem der vorhergehenden Ansprüche, wobei der erste Positionierungsalgorithmus (Alg1) mindestens die folgenden Schritte ausführt:

- man definiert willkürlich die Position (P_E1) der ersten Windenergieanlage (EE1);
- dann für jede zu positionierende Windenergieanlage, nacheinander:

man definiert potenzielle Positionen (PE_Ej) in dem ersten diskreten Netz (RD3) für die zu positionierende Windenergieanlage, wobei die potenziellen Positionen (PE Ej) die diskreten Positionen des ersten diskreten Netzes (RD3) umfassen, die zwischen einem minimalen Abstand und einem maximalen Abstand von allen positionierten Windenergieanlagen gelegen sind, und/oder die diskreten Positionen der Grenze des vorbestimmten Raums (Esp), die in dem minimalen Abstand von allen positionierten Windenergieanlagen gelegen sind;

man berechnet die jährliche Energieerzeugung (Eval_AEP) der positionierten Windenergieanlagen und der zu positionierenden Windenergieanlage für die definierten potenziellen Positionen (PE_Ej) ausgehend von der ersten diskreten Windgeschwindigkeitsverteilung (RD1), von der zweiten diskreten Windrichtungsverteilung (RD2) und von der Eintrittswahrscheinlichkeit (Prob);
Man wählt die Position (Pos_j) der zu positionierenden Windenergieanlage, die dem berechneten maximalen Wert der jährlichen Energieerzeugung entspricht:

- man bestimmt die erste Anordnung (Disp_Ej), die der Position der vorgegebenen Anzahl von Windenergieanlagen in dem vorbestimmten Raum (Esp) entspricht.

10. Verfahren zum Aufbauen eines Windparks nach Anspruch 9, wobei die willkürliche Position der größten Summe der Koordinaten der Positionen des ersten diskreten Netzes (RD3) entspricht.

11. Computerprogrammprodukt, das von einem Kommunikationsnetz heruntergeladen werden kann und/oder auf einem computerlesbaren Medium gespeichert ist und/oder durch einen Prozessor oder einen Server ausführbar ist, umfassend Programmcodeanweisungen, die bei der Ausführung des Programms auf einem Computer oder einem Mobiltelefon das Verfahren nach einem der vorhergehenden Ansprüche implementieren.

12. Windpark, der ausgehend von dem Verfahren zum Aufbauen eines Windparks nach einem der vorhergehenden Ansprüche 1 bis 10 erhalten wird.

**Claims**

1. Method for constructing a wind farm in a predetermined space (Esp) from a predefined number of wind turbines, the construction method comprising a first discrete wind speed distribution (RD1), a second discrete wind direction distribution (RD2) and a probability of occurrence (Prob) of each discrete wind speed value in each discrete wind direction value of said first and second discrete distributions (RD1, RD2), said predetermined space (Esp) being divided into a first discrete mesh (RD3), wherein at least the following successive steps are carried out:

a) determining a first layout (Disp1) of said wind turbines in the first discrete mesh (RD3) of said predetermined space (Esp) using a first positioning algorithm (Alg1);
b) defining a sequential order (OS) of modification of the positions of the wind turbines as determined by the first positioning algorithm (Alg1), and then carrying out at least the following steps iteratively for at least one wind turbine to be repositioned, one by one, in the defined sequential order (OS):

b1) for each wind turbine to be repositioned, determining new possible discrete positions (PDP_i) of the wind turbine to be repositioned by establishing a grid of at least a first predefined length, the grid being centred on the position of the wind turbine to be repositioned, the grid being divided into a pre-established number of meshes, said new possible discrete positions comprising the points of intersection of the meshes, the points of intersection of the meshes being positioned in said predetermined space (Esp) and at a minimum distance from the positions of the other wind turbines;
b2) calculating the average annual energy production (Eval_i) of the predefined number of wind turbines for each possible discrete position of the wind turbine to be repositioned from said first discrete wind speed distribution (RD1), said second discrete wind direction distribution (RD2) and said probability of occurrence (Prob);
b3) choosing the position (Pos_i) of the wind turbine to be repositioned corresponding to the maximum calculated annual energy production value calculated in step b2);
b4) defining a new layout of the wind turbines (Disp_N) in said predetermined space (Esp); and

c) determining a final layout (DispF) corresponding to the last layout obtained, and constructing said wind farm by erecting said wind turbines at the positions of said final layout on the site of the predetermined space so as to generate energy from wind, steps a) and b) being implemented by computerized means, preferably a computer, a mobile telephone or a tablet.

2. Method for constructing a wind farm according to Claim 1, wherein, before step a), statistical wind data are collected by collection means, preferably a lidar sensor, in the predetermined space (Esp) in order to determine the first and second discrete distributions (RD1, RD2) and the probabilities of occurrence (Prob) of each wind speed in each wind direction of the first and second discrete distributions (RD1, RD2).

3. Method for constructing a wind farm according to either of the preceding claims, wherein said predetermined space (Esp) is two-dimensional.

4. Method for constructing a wind farm according to one of the preceding claims, wherein said sequential order (OS) is obtained randomly.

5. Method for constructing a wind farm according to one of the preceding claims, wherein step b) is reiterated (B2) multiple times, preferably modifying the sequential order (OS) in each iteration.

6. Method for constructing a wind farm according to Claim 5, wherein, for each iteration (B2) of step b), a first predefined length smaller than the first predefined length from the preceding iteration is chosen, said pre-established number being the same from one iteration to another, and the iteration of step b) is stopped when the first predefined length becomes smaller than a first threshold.

7. Method for constructing a wind farm according to one of the preceding claims, wherein said predetermined space (Esp) comprises non-connected areas (Es1, Es2).

8. Method for constructing a wind farm according to one of the preceding claims, wherein said predetermined space (Esp) comprises non-convex areas (Z2, Es2).

9. Method for constructing a wind farm according to one of the preceding claims, wherein said first positioning algorithm (Alg1) carries out at least the following steps:

- arbitrarily defining the position (P_E1) of the first wind turbine (EE1);
- then, for each wind turbine to be positioned, successively:

defining potential positions (PE_Ej) in said first discrete mesh (RD3) for the wind turbine to be positioned, said potential positions (PE_Ej) comprising discrete positions of the first discrete mesh (RD3) that are located between a minimum distance and a maximum distance from all positioned wind turbines and/or discrete positions of the boundary of the predetermined space (Esp) that are located at said minimum distance from all positioned wind turbines;
calculating the annual energy production (Eval_AEP) of the positioned wind turbines and of the wind turbine to be positioned for the defined potential positions (PE_Ej) from said first discrete wind speed distribution (RD1), said second discrete wind direction distribution (RD2) and said probability of occurrence (Prob);
choosing the position (Pos_j) of the wind turbine to be positioned corresponding to the maximum calculated annual energy production value:

- determining said first layout (Disp_Ej) corresponding to the position of the predefined number of wind turbines in said predetermined space (Esp).

10. Method for constructing a wind farm according to Claim 9, wherein the arbitrary position corresponds to the greatest sum of the coordinates of the positions of said first discrete mesh (RD3).

11. Computer program product able to be downloaded from a communication network and/or recorded on a computer-readable medium and/or a medium able to be executed by a processor or a server, comprising program code instructions for implementing the method according to one of the preceding claims when the program is executed on a computer or a mobile telephone.

12. Wind farm obtained using the method for constructing a wind farm according to one of preceding Claims 1 to 10.

[Fig 1]

[Fig 2]

[Fig 3]

[Fig 4]

EP 4 193 318 B1

[Fig 5]

25

[Fig 6]

[Fig 7]

[Fig 8]

[Fig 9]

[Fig 10]

a)

Es2

Ar

Es1

b)

EE1

T2

c)

T21

d)

T51

e)

ELi

PDP_ELi

[Fig 11]

a)

Es2   EE2   EE1   Es1

T3

Ar

b)

T11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 105119320
- CN 102142103 A
- CN 105139269
- US 2016171401 A

**Littérature non-brevet citée dans la description**

- **TAO**. Wind farm layout optimization with a three-dimensional Gaussian Wake model. *Renewable Energy*, 09 June 2020
- **ANTONINI**. Continuous adjoint formulation for wind farm layout optimization. *Applied Energy*, 25 July 2018
- **WAGNER**. A fast and effective local search algorithm for optimizing the placement of wind turbines. *Renewable Energy*, 10 October 2012
- **FENG** ; **SHEN**. Solving the wind farm layout optimization problem using random search. *Renewable Energy*, 20 January 2015
- **QUAN** ; **KIM**. Greedy robust wind farm layout optimization with feasability guarantee. *Engineering Optimization*, 06 September 2018
- **KATIC** ; **HOJSTRUP** ; **JENSEN**. A simple model for Cluster Efficiency. *EWEC*, 1986
- **JENSEN, DTU**. *A note on wind generator interaction*, 1983